# EUROPEAN PATENT SPECIFICATION

(11) **EP 4 199 092 B1**
(45) Date of publication and mention of the grant of the patent: **01.10.2025**
(21) Application number: 21855406.1
(22) Date of filing: 03.08.2021
(51) Int. Cl.: H10F 39/00

(54) **MINIATURE SPECTRUM CHIP BASED ON UNITS OF DIFFERENT SHAPES, AND METHOD FOR GENERATING MICRO-NANO STRUCTURE ARRAY IN MINIATURE SPECTRUM CHIP**
MINIATURSPEKTRUMSCHIP AUF BASIS VON EINHEITEN VERSCHIEDENER FORMEN UND VERFAHREN ZUR ERZEUGUNG EINER MIKRO-NANOSTRUKTURANORDNUNG IN EINEM MINIATURSPEKTRUMSCHIP
PUCE À SPECTRE MINIATURE BASÉE SUR DES UNITÉS DE DIFFÉRENTES FORMES, ET PROCÉDÉ DE GÉNÉRATION D'UN RÉSEAU DE MICRO-NANOSTRUCTURES DANS UNE PUCE À SPECTRE MINIATURE

(30) Priority: 14.08.2020 CN 202010820373; 14.08.2020 CN 202010820381; 14.08.2020 CN 202010821286
(43) Date of publication of application: 21.06.2023
(73) Proprietor: Tsinghua University, Beijing 100084 (CN)
(72) Inventor: CUI, Kaiyu, Beijing 100084 (CN); YANG, Jiawei, Beijing 100084 (CN); HUANG, Yidong, Beijing 100084 (CN); ZHANG, Wei, Beijing 100084 (CN); FENG, Xue, Beijing 100084 (CN); LIU, Fang, Beijing 100084 (CN)
(74) Representative: Durm Patentanwälte PartG mbB
(86) International application number: PCT/CN2021/110237
(87) International publication number: WO 2022/033353

(56) References cited:
- CN-A- 110 346 313
- CN-A- 111 490 060
- CN-A- 111 505 820
- CN-A- 112 018 139
- CN-A- 112 018 140
- CN-A- 112 018 141
- CN-U- 211 122 509
- US-A1- 2012 327 398

## Description

### CROSS-REFERENCE TO RELATED APPLICATIONS

The present application claims priorities to Chinese patent application No. 202010821286.5 filed on August 14, 2020, entitled "Micro Spectrum Chip Based on units of different shapes", Chinese patent application No. 202010820381.3 filed on August 14, 2020, entitled "Micro Spectrum Chip Based on units of random shapes", and Chinese patent application No. 202010820373.9 filed on August 14, 2020, entitled "Method for Generating Micro-Nano Structure Array in Spectrum Chip".

### FIELD

The present application relates to the field of spectral imaging, in particular to a micro spectrum chip based on units of different shapes, and a method for generating a micro-nano structure array in spectrum chip.

### BACKGROUND

For traditional spectrometers, it is necessary to spatially separate incident light of different wavelengths through a spectroscopic component and then perform the detection. However, the precise spectroscopic component is usually large in size, which limits the miniaturization of the spectrometer. In addition, the incident light can be modulated by a micro-nano structure array with regular shaped units, and the spectral information of the incident light can be restored from the responses of the detectors with the aid of algorithms. However, in this solution, the broadband spectral modulation effects that may be achieved by changing the period, duty cycle and other parameters of the regular-shaped units are limited, so that not only does it limit the precision of spectral restoration, but it is also difficult to further reduce the size of the device. Therefore, it is of great significance to provide a spectrum chip with higher precision and smaller size.

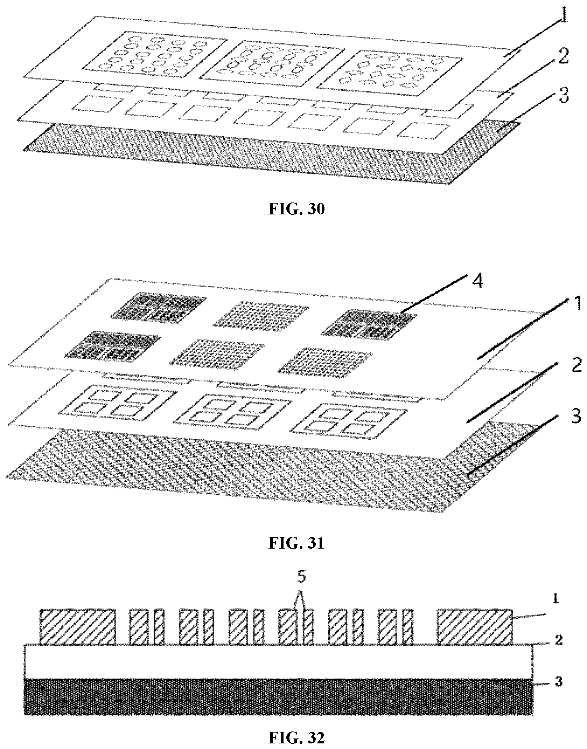

The traditional spectrometers need precise spectroscopic components, and are complex and bulky. At present, incident light can be modulated by a micro-nano structure array with regular shaped units, and the spectral information of the incident light can be restored from the responses of the detectors with the aid of algorithms. For example, as shown in FIG. 30, each unit on the optical modulation layer is provided with a plurality of modulation holes penetrating into a base plate, where the cross-sectional shapes of the modulation holes include a circle, an ellipse, a cross, a regular polygon, a star or a rectangle. In related art, by changing the structural parameters, such as period, duty ratio and angle of the regular shaped units and, the spectral modulation effect is limited. Therefore, not only does it limit the precision of spectral restoration, but it is also difficult to further reduce the size of the device. CN 111 505 820 A discloses a monolithic integrated image sensing chip and spectrum recognition equipment. Alight modulation layer of the chip is integrated on an image sensing layer; the light modulation layer includes at least one sub-modulation layer arranged in the thickness direction of the light modulation layer; each set of pixel confirmation module includes modulation units and induction units; at least one group of modulation units are distributed on the light modulation layer along the surface of the light modulation layer; at least one group of induction units are distributed on the image sensing layer; each group of modulation units and at least one group of induction units are correspondingly arranged along a vertical direction; a signal processing circuit layer is connected to the lower surface of the image sensing layer and is electrically connected with each sensing unit.

CN 111 490 060 A discloses a spectral imaging chip and spectral recognition equipment. The spectral imaging chip includes a light modulation layer, an image sensing layer and a signal processing circuit layer which are sequentially stacked in the thickness direction; at least one modulation unit is distributed on the light modulation layer along the surface; each modulation unit includes a plurality of modulation subunits distributed along the surface, and each modulation subunit has C4 symmetry; the image sensing layer is a CIS wafer, a plurality of sensing units are distributed on the surface of the image sensing layer, and each modulation subunit corresponds to at least one sensing unit in the thickness direction; and the signal processing circuit layer is electrically connected with the sensing units.

### SUMMARY

Embodiments of the present application provide a micro spectrum chip based on units of different shapes, to solve the problems in related art including limited precision of spectral restoration and difficulties in further reducing the size of the device due to the limited broadband spectral modulation effect achievable by the traditional spectrum chip, thereby providing spectrum chip with higher precision and smaller size.

Embodiments of the present application provide a micro spectrum chip based on units of random shapes, to solve the problems in related art including limited precision of spectral restoration and difficulties in further reducing the size of the device due to the limited broadband spectral modulation effect achievable by the traditional spectrum chip, thereby providing spectrum chip with higher precision and smaller size.

In view of the problems in related art, embodiments of the present application provide a method for generating a micro-nano structure array in a spectrum chip.

A micro spectrum chip based on units of different shapes according to an embodiment of the present application, including a CIS wafer and an optical modulation layer; where the optical modulation layer includes one or more micro-nano structure units provided on a surface of a photosensitive area of the CIS wafer, each micro-nano structure unit includes a plurality of micro-nano structure arrays, and the different micro-nano structure arrays in each micro-nano structure unit are two-dimensional gratings formed of internal units of different shapes.

In an embodiment, the one or more micro-nano structure units are identical repeating units, the micro-nano structure arrays located at corresponding positions in different micro-nano structure units are identical, and/or no micro-nano structure array exists at one or more corresponding positions in different micro-nano structure units, and/or, each of the micro-nano structure units has a size of 0.5 µm² to 40000 µm², and/or, each of the micro-nano structure arrays has a period of 20 nm to 50 µm.

In an embodiment, the number of micro-nano structure arrays in each of the micro-nano structure units is dynamically adjustable; and/or, the one or more micro-nano structure units have C4 symmetry.

In an embodiment, each of the micro-nano structure arrays corresponds to one or more pixels on the CIS wafer.

In an embodiment, the micro spectrum chip based on units of different shapes further includes a signal processing circuit connected to the CIS wafer through electrical contact.

In an embodiment, the CIS wafer includes an optical detection layer and a metal wire layer, where the optical detection layer is provided under the metal wire layer and the optical modulation layer is integrated on the metal wire layer; or the optical detection layer is provided above the metal wire layer and the optical modulation layer is integrated on the optical detection layer.

In an embodiment, when the optical detection layer is provided above the metal wire layer, the optical modulation layer is prepared by etching the optical detection layer of the CIS wafer with an etching depth of 50 nm to 2 µm.

In an embodiment, the optical modulation layer has a single-layer structure, a double-layer structure or a multi-layer structure and a thickness of each layer is 50 nm to 2 µm; the optical modulation layer is made of one or more of the following items: silicon, germanium, silicon-germanium material, silicon compound, germanium compound, metal, or III-V group material; where the silicon compound includes silicon nitride, silicon dioxide, and/or silicon carbide; and/or, when the optical modulation layer has the double-layer structure or multi-layer structure, one or more of the layers is not penetrated through.

In an embodiment, a light-transmitting medium layer is provided between the optical modulation layer and the CIS wafer, the light-transmitting medium layer has a thickness of 50 nm to 2 µm, and the light-transmitting medium layer is made of silicon dioxide; the light-transmitting medium layer is prepared on the CIS wafer by chemical vapor deposition, sputtering or spin coating, and then the optical modulation layer is deposited and etched on the light-transmitting medium layer; or the optical modulation layer is prepared on the light-transmitting medium layer, and then the light-transmitting medium layer and the optical modulation layer are transferred to the CIS wafer.

In an embodiment, the micro spectrum chip is integrated with micro-lens and/or optical filters, and the micro-lens and/or the optical filters are provided above or below the optical modulation layer.

In an embodiment, the micro spectrum chip based on units of different shapes includes a CIS wafer and an optical modulation layer; where the optical modulation layer includes one or more micro-nano structure units provided on a surface of a photosensitive area of the CIS wafer, each micro-nano structure unit includes a plurality of micro-nano structure arrays, and the different micro-nano structure arrays in each micro-nano structure units are two-dimensional gratings formed of internal units of random shapes.

In an embodiment, each internal unit of random shapes include two or more curvatures.

An embodiment of the present application provides a method for generating micro-nano structure arrays in a spectrum chip, where the spectrum chip includes:
a wafer-level image sensor, where an upper surface of a photosensitive area of the wafer-level image sensor is provided with an optical modulation layer; the optical modulation layer includes a unit array formed of a plurality of micro-nano units, and each of the micro-nano units corresponds to one or more pixel points on the wafer-level image sensor; and the micro-nano unit includes multiple groups of micro-nano structure arrays, each group of the micro-nano structure arrays is formed in a two-dimensional grating structure, and the two-dimensional grating structure in the multiple groups of micro-nano structure arrays of each micro-nano unit is used for modulating an incident light and encoding spectral information of the incident light to different pixel points of the wafer-level image sensor to obtain an image including the spectral information of the incident light;
where the method for generating the micro-nano structure arrays in a spectrum chip includes: generating the two-dimensional grating structure, where the two-dimensional grating structure is formed by periodically arranging random-shaped structures;
the generating the two-dimensional grating structure includes:
   determining an arrangement period of the random-shaped structures in the two-dimensional grating structure;
   generating each of the random-shaped structures in the two-dimensional grating structure by the following steps:
      meshing an area within the arrangement period to obtain a plurality of mesh areas;
      assigning pixel values to the plurality of mesh areas randomly to obtain an initial pattern corresponding to the random-shaped structures, where mesh areas corresponding to different pixel values have different refractive indexes; and
      binarizing the initial pattern to obtain a first binarized pattern, where the first binarized pattern corresponds to one random-shaped structure, 0 and 1 in the first binarized pattern represent air and a medium, respectively.

In an embodiment, before being binarized, the initial pattern is filtered and smoothed in advance.

In an embodiment, after obtaining the first binarized pattern, the method further includes:
fuzzifying and binarizing the first binarized pattern sequentially to obtain a second binarized pattern, where the second binarized pattern corresponds to one random-shaped structure.

In an embodiment, the assigning pixel values to the plurality of mesh areas randomly to obtain an initial pattern corresponding to the random-shaped structures includes:
grouping the plurality of mesh areas to obtain multiple groups of meshes, where one or more mesh areas constitute one group when the plurality of mesh areas are grouped; and
assigning the pixel values to each group of meshes randomly according to a standard normal distribution to obtain the initial pattern corresponding to the random-shaped structures, where the mesh areas in one group have the same pixel values.

In an embodiment, during generation of each of the random-shaped structures in the two-dimensional grating structure, the method further includes: controlling a minimum size of the random-shaped structures to be greater than a preset threshold value and a ratio of medium to air in the random-shaped structure to satisfy a preset constraint condition by controlling one or more of the following parameters: a meshing parameter corresponding to the meshing operation, a random assignment parameter corresponding to pixel value random assignment operation, a filtering and smoothing parameter corresponding to filtering and smoothing operation, or a fuzzification parameter corresponding to fuzzifying operation.

In an embodiment, after obtaining the first binarized pattern or the second binarized pattern, the method further includes: performing symmetry processing on the first binarized pattern or the second binarized pattern to obtain a pattern with symmetry, where the pattern with symmetry corresponds to one random-shaped structure;
where the symmetry processing includes one or more of the following items: two-fold rotational symmetry processing, Y-axis mirror symmetry processing, X-axis mirror symmetry processing, both Y-axis and X-axis mirror symmetry processing, four-fold rotational symmetry processing, or both Y-axis and X-axis mirror symmetry and four-fold rotational symmetry processing;
the pattern with symmetry includes one or more of the following items:
   a pattern with two-fold rotational symmetry, a pattern with Y-axis mirror symmetry , a pattern with X-axis mirror symmetry, a pattern with both Y-axis and X-axis mirror symmetry, a pattern with four-fold rotational symmetry, or a pattern with both Y-axis and X-axis mirror symmetry and four-fold rotational symmetry.

In an embodiment, after obtaining the first binarized pattern or the second binarized pattern, the method further includes: dilating or eroding the first binarized pattern or the second binarized pattern, to simulate insufficient or excessive etching in the process preparation.

In an embodiment, the spectrum chip further includes: a signal processing circuit connected with the wafer-level image sensor;
where the signal processing circuit is used for processing the image including spectral information of the incident light to obtain the spectral information of the incident light.

In an embodiment, a light-transmitting medium layer is provided between the optical modulation layer and the wafer-level image sensor.

In an embodiment, the wafer-level image sensor is front-side illuminated, and includes a metal wire layer and an optical detection layer arranged from up to down, where the optical modulation layer is integrated on a side of the metal wire layer distal to the optical detection layer; or
the wafer-level image sensor is back-side illuminated, and includes an optical detection layer and a metal wire layer arranged from up to down, where the optical modulation layer is integrated on a side of the optical detection layer distal to the metal wire layer.

In an embodiment, the spectrum chip further includes: a micro-lens and/or an optical filter;
the micro-lens is arranged on a side of the optical modulation layer distal to the wafer-level image sensor, or the micro-lens is arranged on a side of the optical modulation layer proximal to the wafer-level image sensor; and
the light filter is arranged on the side of the optical modulation layer distal to the wafer-level image sensor, or the light filter is arranged on the side of the optical modulation layer proximal to the wafer-level image sensor.

In the method for generating a micro-nano structure array in a spectrum chip according to the embodiments of the present application, the area within the arrangement period is meshed to obtain a plurality of mesh areas, the pixel values are randomly assigned to the plurality of mesh areas to obtain the initial pattern, and then the initial pattern is filtered and smoothed and binarized to obtain random-shaped structure. Since each group of micro-nano structure arrays, namely each two-dimensional grating structure, is formed of the random-shaped structures generated in such a random way, the optical modulation layer including multiple groups of micro-nano structure arrays includes a variety of random-shaped structures. Therefore, the optical modulation layer has abundant broadband spectral modulation effects on incident light, which is conducive to overcoming the limitation to precision of spectral restoration to obtain high-precision measurement for the incident light spectrum and to improve the precision of spectral restoration.

Regarding the micro spectrum chip based on units of different shapes according to the embodiments of the present application, in each micro-nano structure unit, different micro-nano structure arrays have different shapes of the internal units, and each group of micro-nano structure arrays has different modulation effects on light with different wavelengths; the degree of freedom of "shape" is fully utilized to obtain a rich modulation effect on the incident light, such that the precision of spectral restoration is improved and the size of each unit may be reduced; a two-dimensional grating structure based on internal units of different shapes is utilized, so as to bring abundant broadband spectral modulation effect on incident light and obtain high-precision measurement of incident light spectrum.

### BRIEF DESCRIPTION OF THE DRAWINGS

In order to more clearly illustrate solutions according to the embodiments of the present application or the related art, the drawings needed in the descriptions of the embodiments or the related art will be briefly described below. It should be noted that the drawings in the following description only show part embodiments of the present application, and other drawings can be obtained according to the drawings without any creative work for those skilled in the art.
FIG. 1 is a schematic diagram showing a lateral structure of a micro spectrum chip based on units of different shapes according to an embodiment of the present application;
FIG. 2 is a schematic diagram showing a longitudinal structure of a micro spectrum chip based on units of different shapes according to an embodiment of the present application;
FIG. 3 is a schematic diagram showing a lateral structure of an optical modulation layer in a micro spectrum chip based on units of different shapes according to an embodiment of the present application;
FIG. 4 is a schematic diagram showing a lateral structure of an optical modulation layer in a micro spectrum chip based on units of different shapes according to an embodiment of the present application;
FIG. 5 is a schematic diagram showing a lateral structure of an optical modulation layer in a micro spectrum chip based on units of different shapes according to an embodiment of the present application;
FIG. 6 is a schematic diagram showing a longitudinal structure of a front-side illuminated CMOS image sensor (CIS) wafer in a micro spectrum chip based on units of different shapes according to an embodiment of the present application;
FIG. 7 is a schematic diagram showing a longitudinal structure of a back-side illuminated CIS wafer in a micro spectrum chip based on units of different shapes according to an embodiment of the present application;
FIG. 8 is a schematic diagram showing a longitudinal structure of a single-layer grating as an optical modulation layer in a micro spectrum chip based on units of different shapes according to an embodiment of the present application;
FIG. 9 is a schematic diagram showing a longitudinal structure of a double-layer grating as an optical modulation layer in a micro spectrum chip based on units of different shapes according to an embodiment of the present application;
FIG. 10 is a schematic diagram showing a longitudinal structure of a multi-layer grating as an optical modulation layer in a micro spectrum chip based on units of different shapes according to an embodiment of the present application;
FIG. 11 is a schematic diagram showing a longitudinal structure of a multi-layer grating as an optical modulation layer while one of the layers is not penetrated in a micro spectrum chip based on units of different shapes according to an embodiment of the present application;
FIG. 12 is a schematic diagram showing an etching longitudinal structure of an optical modulation layer and a back-side illuminated CIS wafer in a micro spectrum chip based on units of different shapes according to an embodiment of the present application;
FIG. 13 is a schematic diagram showing a lateral structure of a micro spectrum chip based on units of different shapes according to an embodiment of the present application;
FIG. 14 is a schematic diagram showing a lateral structure of an optical modulation layer in a micro spectrum chip based on units of different shapes according to an embodiment of the present application;
FIG. 15 is a schematic diagram showing a longitudinal structure of a micro spectrum chip based on units of different shapes according to an embodiment of the present application;
FIG. 16 is a schematic diagram of a process for multi-spectral image acquisition according to an embodiment of the present application;
FIG. 17 is a schematic diagram showing a lateral structure of an optical modulation layer in a micro spectrum chip based on units of different shapes according to an embodiment of the present application;
FIG. 18 is a schematic diagram showing a longitudinal structure of a micro spectrum chip based on units of different shapes according to an embodiment of the present application;
FIG. 19 is a schematic diagram showing a longitudinal structure of a micro spectrum chip based on units of different shapes according to an embodiment of the present application;
FIG. 20 is a schematic diagram showing a longitudinal structure of an optical modulation layer in a micro spectrum chip based on units of different shapes according to an embodiment of the present application;
FIG. 21 is a schematic diagram showing a longitudinal structure of an optical modulation layer in a micro spectrum chip based on units of different shapes according to an embodiment of the present application;
FIG. 22 is a schematic diagram showing a longitudinal structure of a CIS wafer in a micro spectrum chip based on units of different shapes according to an embodiment of the present application;
FIG. 23 is a schematic diagram showing a longitudinal structure of a micro spectrum chip based on units of different shapes according to an embodiment of the present application;
FIG. 24 is a schematic diagram showing a longitudinal structure of a micro spectrum chip based on units of different shapes according to an embodiment of the present application;
FIG. 25 is a schematic diagram showing a longitudinal structure of a micro spectrum chip based on units of different shapes according to an embodiment of the present application;
FIG. 26 is a schematic diagram showing a longitudinal structure of a micro spectrum chip based on units of different shapes according to an embodiment of the present application;
FIG. 27 is a schematic diagram showing a longitudinal structure of a micro spectrum chip based on units of different shapes according to an embodiment of the present application;
FIG. 28 is a schematic diagram showing a longitudinal structure of a micro spectrum chip based on units of different shapes according to an embodiment of the present application;
FIG. 29 is a schematic diagram showing randomly generated irregular shapes in a micro spectrum chip based on units of random shapes according to an embodiment of the present application;
FIG. 30 is a schematic structural diagram of a spectrum chip according to the related art;
FIG. 31 is a schematic structural diagram of a spectrum chip according to an embodiment of the present application;
FIG. 32 is a schematic sectional view of a spectrum chip according to an embodiment of the present application;
FIG. 33 is a flow chart of generating a two-dimensional grating structure according to an embodiment of the present application;
FIG. 34 is a schematic diagram of generating a two-dimensional grating structure according to an embodiment of the present application;
FIG. 35 is a schematic diagram of generating a two-dimensional grating structure according to another embodiment of the present application;
FIG. 36 is a schematic diagram of generating a two-dimensional grating structure according to yet another embodiment of the present application;
FIG. 37 is a schematic diagram of a pattern with two-fold rotational symmetry according to an embodiment of the present application;
FIG. 38 is a schematic diagram of a pattern with Y-axis mirror symmetry according to an embodiment of the present application;
FIG. 39 is a schematic diagram of a pattern with X-axis mirror symmetry according to an embodiment of the present application;
FIG. 40 is a schematic diagram of a pattern with both Y-axis and X-axis mirror symmetry according to an embodiment of the present application;
FIG. 41 is a schematic diagram of a pattern with four-fold rotational symmetry according to an embodiment of the present application;
FIG. 42 is a schematic diagram of a pattern with both Y-axis and X-axis mirror symmetry and four-fold rotational symmetry g according to an embodiment of the present application;
FIG. 43 is a schematic diagram of a random-shaped structure according to an embodiment of the present application;
FIG. 44 is a schematic diagram of a random-shaped structure obtained after eroding a medium area according to an embodiment of the present application;
FIG. 45 is a schematic diagram of a random-shaped structure obtained after dilating a medium area according to an embodiment of the present application;
FIG. 46 is a schematic diagram showing a working process of a spectrum chip according to an embodiment of the present application.

### DETAILED DESCRIPTION

In order to illustrate the objectives, solutions and advantages of the embodiments of present application more clearly, the solutions in the embodiments of the present application will be described clearly and completely in conjunction with the accompanying drawings in the embodiments of the present application. It should be noted that the described embodiments are part of the embodiments of the present application, rather than all of the embodiments. All other embodiments obtained by a person of ordinary skill in the art based on the embodiments of the present application without creative effort are within the protection scope of the present application.

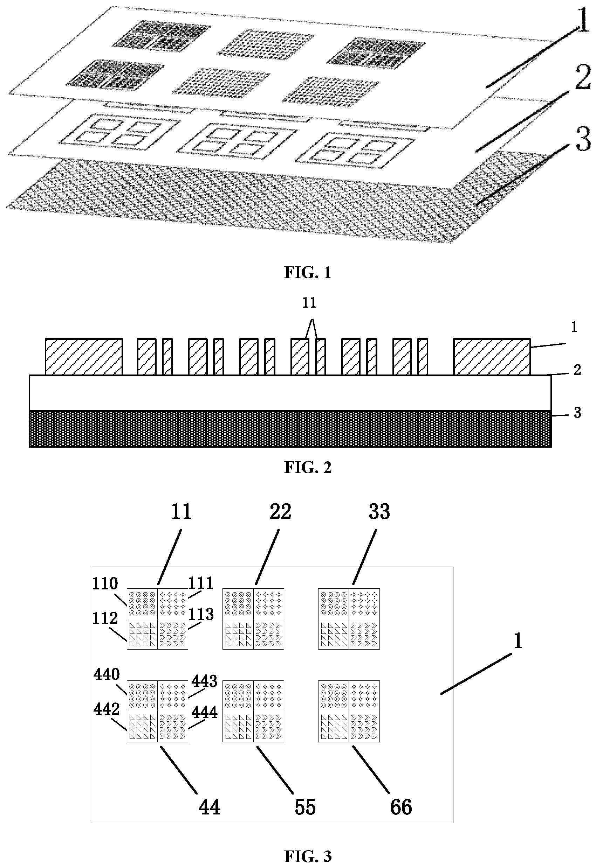

A micro spectrum chip based on units of different shapes according to an embodiment of the present application will be described as follows with reference to FIG. 1. The micro spectrum chip includes a CMOS image sensor (CIS) wafer 2 and an optical modulation layer 1; the optical modulation layer 1 includes one or more micro-nano structure units arranged on a surface of a photosensitive area of the CIS wafer 2, each micro-nano structure unit includes a plurality of micro-nano structure arrays, and in each micro-nano structure unit, different micro-nano structure arrays are two-dimensional gratings including internal units of different shapes. In an embodiment, the internal units of different shapes according to the present application refer to the units of different shapes and/or different sizes. In an example, when using the above micro spectrum chip, the output spectral signals for the same light are inconsistent after being modulated by the internal units of different shapes.

FIG. 1 shows a structural schematic diagram of a micro spectrum chip based on units of different shapes according to the present application. As shown in FIG. 1, the micro spectrum chip includes an optical modulation layer 1, a CIS wafer 2 and a signal processing circuit 3. After passing through the optical modulation layer 1, the incident light is converted into an electrical signal through the CIS wafer 2, and then being processed and output by the signal processing circuit 3. The optical modulation layer 1 includes a plurality of repeating micro-nano structure units, each of which is formed of multiple groups of micro-nano structure arrays and may contain more than 8 array groups, and the overall size is 0.5 µm² to 40000 µm². In each micro-nano structure unit, different micro-nano structure arrays have different shapes of internal units, and each micro-nano structure array has a period of 20 nm to 50 µm. The internal units of different shapes have different modulation effects on lights with different wavelengths, and each group of micro-nano structure array corresponds to one or more photosensitive pixels of CIS wafer in the vertical direction. After passing through the optical modulation layer 1, the incident light is modulated by each group of micro-nano structure arrays in the unit. The intensity of the modulated light signal is detected by the CIS wafer 2 and converted into an electrical signal which is then processed by the signal processing circuit 3, and the spectral information of the incident light is restored using an algorithm. The optical modulation layer 1 is arranged on the CIS wafer in a monolithic integrated manner. In this embodiment, a two-dimensional grating structure based on units of different shapes is utilized, and the free variable of "shape" is fully utilized to obtain a abundant modulation effect on the incident light, such that the precision of spectral restoration is improved and the unit size may be reduced. A two-dimensional grating structure based on internal units of different shapes is utilized, so as to bring abundant broadband spectral modulation characteristics to incident light and measure incident light spectrum in a high-precision manner. The monolithic integration of the optical modulation layer based on units of different shapes and image sensors, without discrete components, is conducive to improving the stability of the device, greatly promoting the miniaturization and lightweight of imaging spectrometers, and has a broad prospect for applications on small platforms such as small satellites and UAVs. Through monolithic integration at a wafer level, the distance between the sensor and the optical modulation layer may be minimized, which is conducive to reducing the size of the units, achieving higher spectral resolution and decreasing the packaging costs.

In an embodiment, the optical modulation layer can only be defined as one micro-nano structure unit which is formed of multiple groups of micro-nano structure arrays, where the shapes of the micro-nano structure arrays at different areas can be the same or different. For example, the optical modulation layer is obtained by arranging a plurality of different internal units according to a certain rule, where the different internal units are designed or randomly generated. For example, the optical modulation layer is obtained by duplicating and arranging the plurality of different internal units.

In another embodiment, two or more micro-nano structure units are different. For example, the micro-nano structure units being different means that the numbers of micro-nano structure arrays included therein are different, or the arrangements and/or shapes of internal units included in the micro-nano structure arrays are different, or both the numbers of micro-nano structure arrays and the arrangements and/or shapes of internal units are different. Through this embodiment, more spectral signals can be generated by the whole spectrum to further improve the precision. In an embodiment, all micro-nano structure units are different. It should be noted that, in this embodiment, some micro-nano structure units can be designed and/or selected independently, so as to achieve some specific requirements, such as to obtain better spectral information, to facilitate process, or to obtain image information, etc. Therefore, in this embodiment, two or more micro-nano structure units have different structures and modulation effects. For example, in order to obtain image information, one or more of the micro-nano structure units are not etched or processed, so that light can directly pass through the optical modulation layer while not be modulated, and the CIS can directly receive image information, and some of the other micro-nano structure units modulates the light to obtain spectral information.

In an embodiment, one micro-nano structure unit includes four kinds of internal units to obtain better effect. In this way, the micro spectrum chip will generate four or more different spectral signals in case of the same light input. In the present application, internal units of different shapes have different modulation effects on lights with different wavelengths, thereby generating more spectral signals, and by detecting the spectral signals generated after the light passes through various units, the spectral information of light to be measured can be restored with the aid of algorithms. Since the spectral signals generated by the present application are abundant, the restored spectral information is more accurate. In a preferred embodiment, the optical modulation layer includes nine or more kinds of internal units, which can ensure that the information obtained by modulating the light is abundant and the calculated spectrum is more accurate. In an embodiment, the micro-nano structure unit of the optical modulation layer includes a square number, such as 4, 9 or 16, etc., of the micro-nano structure arrays, which is convenient for designing and processing and can reduce the difficulty of spectral calculation.

From a longitudinal perspective, as shown in FIG. 2, each group of micro-nano structure arrays in the optical modulation layer 1 is a two-dimensional grating based on different shaped internal units 11, which may be prepared by growing one or more layers of dielectric or metallic materials directly on the CIS wafer 2, followed by etching. Each group of micro-nano-structure arrays may be configured to modulate different wavelengths of light in the target range differently by changing the geometry of internal units 11. The thickness of the optical modulation layer 1 is 50 nm to 2 µm, and each group of micro-nano structure arrays in the optical modulation layer 1 corresponds to one or more pixels on the CIS wafer 2. The optical modulation layer 1 is directly prepared on the CIS wafer 2, and the CIS wafer 2 and the signal processing circuit 3 are connected through electrical contact. In this embodiment, the optical modulation layer 1 is monolithically integrated directly on the CIS wafer 2 at the wafer level, and the spectrum chip may be prepared in a single flow using the CMOS process. Compared with traditional spectral imaging equipment, in this embodiment, the optical modulation layer 1 and the CIS wafer 2 based on units of different shapes are monolithically integrated without discrete components, which is beneficial to improve the stability of the device and reduce the volume and cost of the device.

In an embodiment, in the micro spectrum chip based on internal units of different shapes mentioned in the above embodiments, the internal units can be designed according to actual requirements, or be generated randomly, for example, generated randomly with a help of algorithm, or can be obtained by adjusting the results randomly generated by the algorithm according to actual requirements. In an embodiment, the internal units of the optical modulation layer can be designed by manual work or generated randomly.

In an embodiment of the present application, the high-precision micro spectrum chip is formed of internal units of random shapes. As shown in FIG. 1, the micro spectrum chip includes an optical modulation layer 1, a CIS wafer 2, and a signal processing circuit 3. After passing through the optical modulation layer 1, the incident light is converted into an electrical signal through the CIS wafer 2, and then processed and output by the signal processing circuit 3. The optical modulation layer 1 contains a plurality of repeating micro-nano structure units, each of which is formed of multiple groups of micro-nano structure arrays, and each of the micro-nano structure units includes eight or more groups of arrays and has an overall size of 0.5 µm² ~40000 µm². The shapes of the internal units of different micro-nano structure arrays in each micro-nano structure unit can be different or partially same. The shapes of the internal units are generated randomly and are irregular. In an embodiment, different micro-nano structure arrays have different shapes of the internal units and each micro-nano structure array has a period of 20 nm to 50 µm. The internal units of different shapes have different modulation effects on lights with different wavelengths, the spectral information of the light to be measured can be restored with an aid of algorithm by detecting the responses of the light after the light passes through the units. Each group of micro-nano structure arrays corresponds to one or more photosensitive pixels of CIS wafer in the vertical direction. After passing through the optical modulation layer 1, the incident light is modulated by the groups of micro-nano structure arrays in the unit, and the intensity of the modulated light signal is detected by the CIS wafer 2 and converted into an electrical signal which is then processed by the signal processing circuit 3 to restore and obtain the spectral information of the incident light with a help of algorithm. The optical modulation layer 1 is arranged on the CIS wafer in a monolithic integration manner. In the two-dimensional grating structure based on units of different shapes according to the embodiments of the present application, the degree of freedom of "shape" is utilized to obtain a rich modulation effect on the incident light, which can improve the precision of spectral restoration and reduce the size of units. The internal units of random shapes are different irregular shapes with a large number randomly generated based on a preset condition, which can generate rich modulation effects on the incident light, and is conducive to improving the precision of spectral restoration. The two-dimensional grating structure based on internal units of different shapes has abundant broadband spectral modulation effects on incident light, and can measure the incident light spectrum in a high-precision manner. The monolithic integration of the optical modulation layer based on units of different shapes and image sensors, without discrete components, is conducive to improving the stability of the device, greatly promoting the miniaturization and lightweight of imaging spectrometers, and has a broad prospect for applications on small platforms such as small satellites and UAVs. Through monolithic integration at a wafer level, the distance between the sensor and the optical modulation layer may be minimized, which is conducive to reducing the size of the units, achieving higher spectral resolution and decreasing packaging costs.

The above irregular shapes can be random shapes generated by an algorithm. In an embodiment, the process of the algorithm is as follows: firstly, uniformly meshing an area within a period, where the size of the meshes can be flexibly set; secondly, assigning an refractive index to each of the meshes according to a certain distribution rule, such as a standard normal distribution rule, where the refractive indexes are only numerical values and does not represent the refractive indexes of real materials; and finally, performing image filtering and smoothing processing and binarization processing on the refractive indexes distribution. At this time, only two values 0 and 1 are in the refractive indexes distribution, where 0 represents air and 1 represents medium. In an embodiment, in order to eliminate the part with too small size in the structure for facilitating process preparation, it is also needed to perform fuzzification and binarization. In the final generated image, 0 represents air area and 1 represents medium area, and no structure with too small size is included, which is conducive to process preparation. In addition, specific restriction can be imposed on the generated random structures. For example, if the structure is required to have certain symmetry, the refractive indexes distribution can be processed symmetrically in the algorithm. In an embodiment, the minimum feature size and other characteristics of the generated random shapes can be adjusted by modifying the parameters in the algorithm.

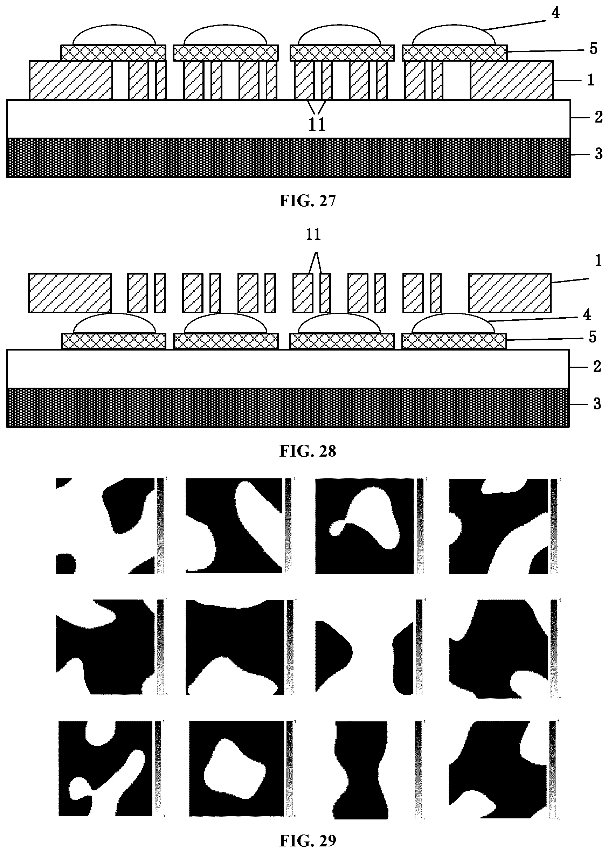

FIG. 29 shows some random shapes generated by algorithm, where the number 0 represents air area and number 1 represents medium area. It can be seen that the algorithm can generate a large number of different irregular shapes, which can generate rich modulation effects on the incident light, and is conducive to improving the precision of spectral restoration.

From a longitudinal perspective, as shown in FIG. 2, each group of micro-nano structure arrays in the optical modulation layer 1 is a two-dimensional grating based on different shaped internal units 11, which may be prepared by growing one or more layers of dielectric or metallic materials directly on the CIS wafer 2, followed by etching. Each group of micro-nano-structure arrays may be configured to modulate different wavelengths of light in the target range differently by changing the geometry of internal units 11. The thickness of the optical modulation layer 1 is 50 nm to 2 µm, and each group of micro-nano structure arrays in the optical modulation layer 1 corresponds to one or more pixels on the CIS wafer 2. The optical modulation layer 1 is directly prepared on the CIS wafer 2, and the CIS wafer 2 and the signal processing circuit 3 are connected through electrical contact. In this embodiment, the optical modulation layer 1 is monolithically integrated directly on the CIS wafer 2 at the wafer level, and the spectrum chip may be prepared in a single flow using the CMOS process. Compared with traditional spectral imaging equipment, in this embodiment, the optical modulation layer 1 and the CIS wafer 2 based on units of different shapes are monolithically integrated without discrete components, which is beneficial to improve the stability of the device and reduce the volume and cost of the device.

The optical modulation layer 1 is etched with various micro-nano structure arrays formed of two-dimensional gratings with different shaped structures as internal units and configured to modulate the received light, and different structures have different modulation effects. From a lateral perspective, in terms of the optical modulation layer 1, the following three solutions are provided.

### Solution 1

As shown in FIG. 3, a plurality of repeating micro-nano structure units, such as 11, 22, 33, 44, 55, 66 exist on a plate. Each unit includes multiple groups of micro-nano structure arrays, and the micro-nano structure arrays at the same position in different units are the same. For example, the micro-nano structure array included in the micro-nano structure unit 11 includes a first group of two-dimensional gratings 110 having a first shape, a second group of two-dimensional gratings 111 having a second shape, a third group of two-dimensional gratings 112 having a third shape, and a fourth group of two-dimensional gratings 113 having a fourth shape; also for example, the micro-nano structure array included in the micro-nano structure unit 44 includes a first group of two-dimensional gratings 440 having a first shape, a second group of two-dimensional gratings 443 having a second shape, a third group of two-dimensional gratings having a third shape, and a fourth group of two-dimensional gratings 444 having a fourth shape. It can be seen that the shapes of the internal units of different micro-nano structure arrays are different, the shapes of the internal units composing the two-dimensional grating of the same micro-nano structure array are the same, and the internal units are actually internal grating units composing the two-dimensional grating. Each group of micro-nano structure arrays in the micro-nano structure unit has different modulation effects on light of different wavelengths, and the modulation effects on the input light are also different between the groups of micro-nano structures. Specific modulation methods include, but are not limited to, scattering, absorption, interference, surface plasmons, resonance enhancement, and so on. By changing the shape of the unit, the corresponding transmission spectra are different after light passes through different groups of micro-nano structures. Corresponding sensors are arranged below each group of micro-nano structure arrays for detecting light intensity after light is modulated by the micro-nano structure arrays. Each unit and the light sensor underneath form a pixel point. The spectral information on each pixel point, that is, the intensity distribution of each wavelength, may be obtained through the restoration algorithm in the prior art; multiple pixels form an image containing spectral information.

### Solution 2

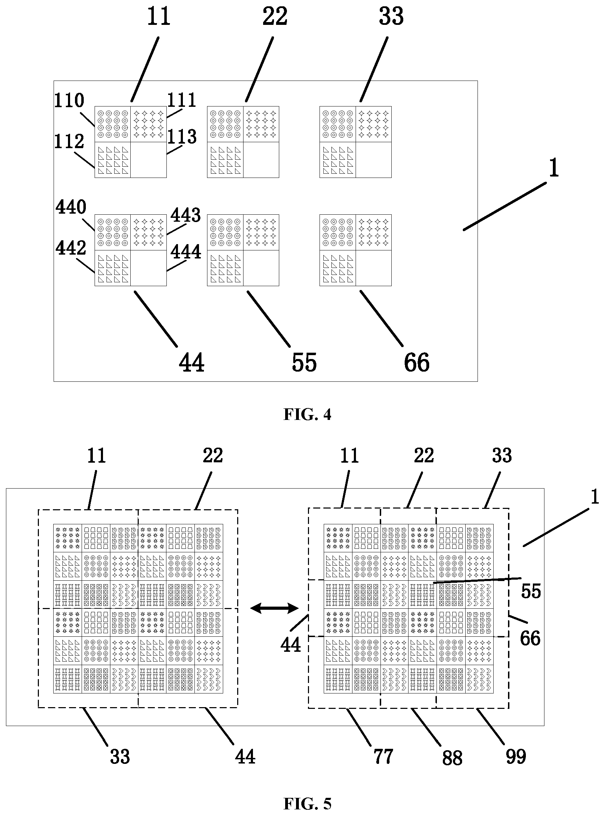

As shown in FIG. 4, a plurality of repeating micro-nano structure units, such as 11, 22, 33, 44, 55, 66 exist on a plate. Each unit includes multiple groups of different micro-nano structure arrays, and the micro-nano structure arrays at the same position in different units are the same. Corresponding sensors are arranged below each group of micro-nano structure arrays. For example, the micro-nano structure array included in the micro-nano structure unit 11 includes a first group of gratings 110 having a first shape, a second group of gratings 111 having a second shape, and a third group of gratings 112 having a third shape, with a fourth group 113 being empty; also for example, the micro-nano structure array included in the micro-nano structure unit 44 includes a first group of gratings 440 having a first shape, a second group of gratings 443 having a second shape, and a third group of gratings 442 having a third shape, with a fourth group 444 being empty. It can be seen that the micro-nano structure array used in this solution is basically the same as that of the first solution. The difference is that there is no micro-nano structure in one of the groups where the incident light can directly penetrate through, which can be used for imaging and/or calibrating the intensity of the light directly penetrating through this unit. It should be noted that FIG. 4 of the present application is only an example for easy understanding and the positions without micro-nano structure in other embodiments can be greater than or equal to two groups.

### Solution 3

As shown in FIG. 5, a plurality of repeating micro-nano structure units, such as 11, 22, 33, 44, 55, 66, 77, 88 exist on a plate. Each micro-nano structure unit includes multiple groups of different micro-nano structure arrays, and corresponding sensors are arranged below each group of micro-nano structure arrays. The difference between Solution 3 and Solution 1 is that the number of micro-nano structure arrays contained in each micro-nano structure unit is dynamically adjustable. For example, the left side of FIG. 5 shows that each unit contains nine groups of micro-nano structure arrays, and the right side thereof shows that each micro-nano structure unit contains four groups of micro-nano structure arrays. The more arrays each micro-nano structure unit contains, the higher the precision of spectral restoration is and the better the anti-noise performance is, but the lower the spectral pixel density is. A balance between the precision of spectral restoration and spectral pixel density may be achieved through this dynamic combination scheme. In an embodiment, one micro-nano structure unit can include two or more same micro-nano structure arrays.

Depending on the requirements, two alternative solutions are available for the specific structure of the CIS wafer 2.

### Solution 1

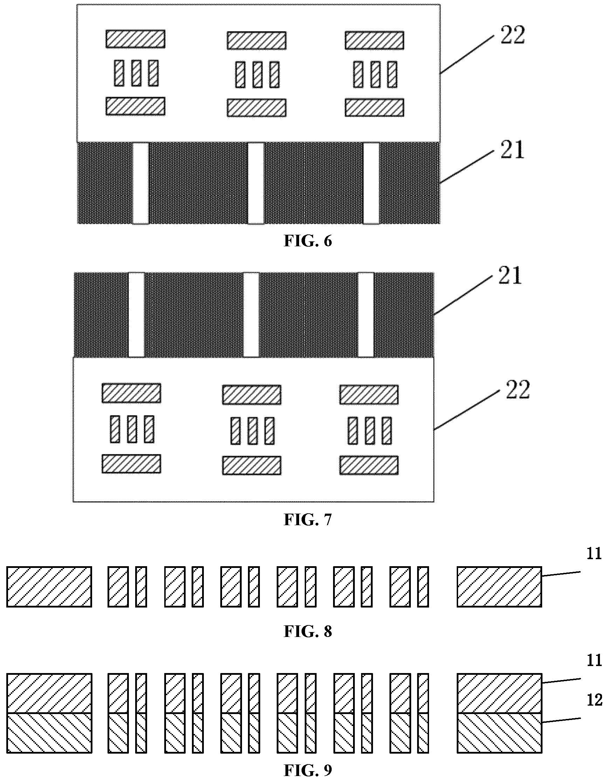

As shown in FIG. 6, the CIS wafer 2 is front-side illuminated, the optical detection layer 21 is under the metal wire layer 22, the CIS wafer is not integrated with micro-lens and light filter, and the optical modulation layer 1 is directly integrated on the metal wire layer 22.

### Solution 2

As shown in FIG. 7, the CIS wafer 2 is back-side illuminated, the optical detection layer 21 is above the metal wire layer 22, the CIS wafer is not integrated with micro-lens and light filter, and the optical modulation layer 1 is directly integrated on the optical detection layer 21.

From a longitudinal perspective, the optical modulation layer 1 may be formed of one or more layers of materials to increase the spectral modulation capability and sampling capability of the optical modulation layer 1 for incident light, which is beneficial to improve the precision of spectral restoration. According to the longitudinal direction, the optical modulation layer 1 may have the following four solutions. Regarding the longitudinal direction, the following four solutions of the optical modulation layer 1 are provided.

### Solution 1

As shown in FIG. 8, the optical modulation layer 1 is a single-layer grating structure of a single material, the grating units are of different shapes and structures, having a thickness of 50 nm to 2 µm. Specific materials may include silicon, germanium, silicon-germanium materials, silicon compounds, germanium compounds, metals, III-V group materials, etc., wherein the silicon compounds include but are not limited to silicon nitride, silicon dioxide, and silicon carbide.

### Solution 2

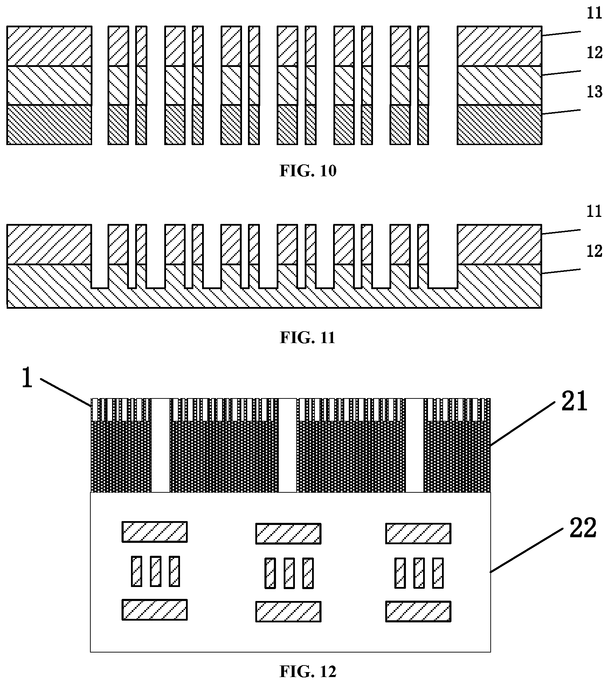

As shown in FIGS. 9 and 10, the optical modulation layer 1 may be formed of two or more layers of materials, wherein all the layers 11, 12, and 13 are made of different materials, and the thickness of each layer is 50 nm to 2 µm. Specific materials may include silicon, germanium, silicon-germanium materials, silicon compounds, germanium compounds, metals, III-V group materials, etc., wherein the silicon compounds include but are not limited to silicon nitride, silicon dioxide, and silicon carbide.

### Solution 3

As shown in FIG. 11, the optical modulation layer 1 may be formed of multiple layers or mixed materials, wherein layers 11 and 12 are of different materials, and one or more layers may not be penetrated through. In FIG. 11, layer 12 is not penetrated through, and the thickness of each layer is 50 nm to 2 µm. Specific materials may include silicon, germanium, silicon-germanium materials, silicon compounds, germanium compounds, metals, III-V group materials, mixed sputtering materials of Si and SiN, etc., wherein the silicon compounds include but are not limited to silicon nitride, silicon dioxide, and silicon carbide.

### Solution 4

As shown in FIG. 12, the optical modulation layer 1 is prepared by directly etching the structure on the optical detection layer 21 of the back-side illuminated CIS wafer, with an etching depth of 50 nm to 2 µm.

With reference to specific embodiments, the micro spectrum chip based on units of different shapes of the present application will be further described as follows.

### Embodiment 1

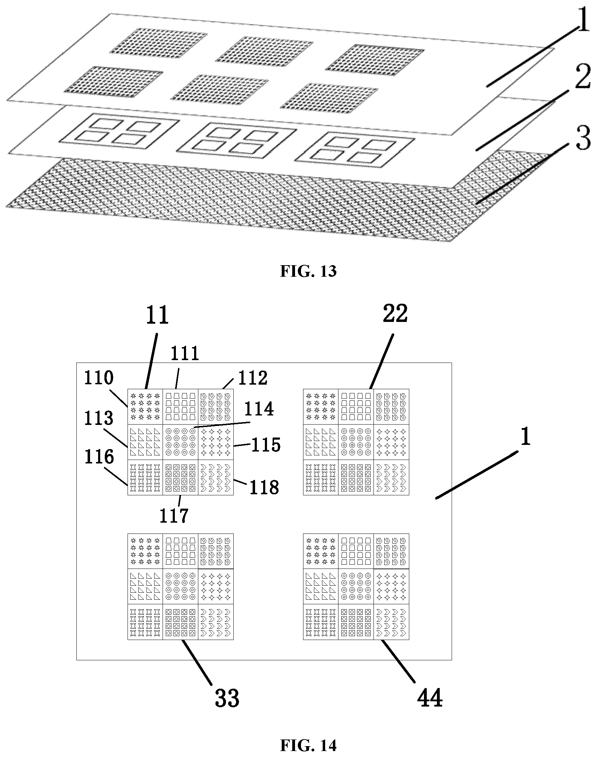

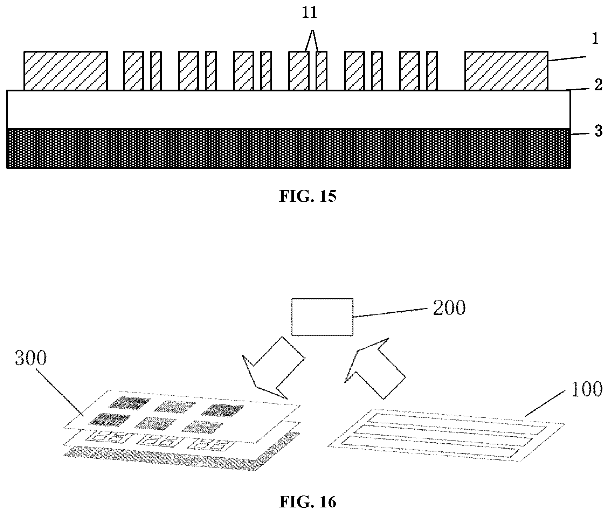

As shown in FIG. 13, the spectrum chip includes an optical modulation layer 1, a CIS wafer 2 and a signal processing circuit 3. The optical modulation layer 1 is directly prepared on the CIS wafer, its lateral structure adopts the above-mentioned Solution 1, and the specific structure is shown in FIGS. 14 and 15. The optical modulation layer 1 includes a plurality of repeating micro-nano structure units, each of which is divided into nine groups of different micro-nano structure arrays 110 to 118. Each group of micro-nano structure arrays is based on gratings with different shape units, the shape of the grating may be a regular shape such as circle, ring, polygon, cross or some other preset irregular shapes, and each group of micro-nano structure arrays has a period of 20 nm to 50 µm; each group of micro-nano structure arrays has different broadband spectral modulation effects on incident light, the micro-nano structure arrays of different micro-nano structure units at corresponding positions are the same, and the overall size of each unit is 0.5 µm² to 40,000 µm². The dielectric material in the optical modulation layer 1 is polysilicon, and the thickness is 50 nm to 2 µm.

The above-mentioned irregular shape can be a random shape generated by an algorithm, but cannot be a limitation. In an embodiment, the irregular shape in the present application can be obtained by one or more algorithms, or can be obtained by a combination of artificial adjustment and algorithms. In an embodiment, the present application provides an algorithm, which includes the following steps: firstly, uniformly meshing the area within a period, the size of the mesh being flexibly set. Secondly, assigning the refractive index to each mesh point on the mesh according to a certain distribution rule, usually the standard normal distribution being selected for distribution; it should be emphasized that the refractive index assigned here is only a numerical value which does not represent the refractive index of the real material. Thirdly, performing image filtering and smoothing processing and binarization processing on the refractive index distribution, at which time only two values of 0 and 1 representing air and medium, respectively are obtained in the refractive index distribution. In order to eliminate undersized parts of the structure for process preparation, a blurring process is also required, as well as a binarization process, in which the values 0 and 1 in the final generated image indicate the regions of air and medium, respectively, and undersized structures for process processing will not be contained, being convenient for processing. In addition, specific restrictions may be made on the generated random structures; for example, if the structure is required to have a certain symmetry, the refractive index distribution may be symmetrized using the algorithm; moreover, by modifying the parameters in the algorithm, the characteristics such as the minimum feature size of the generated random shape may be adjusted.

Some random shapes generated by this algorithm are shown in FIG. 29, where the numbers 0 and 1 indicate the regions of air and medium, respectively. It can be seen that through this algorithm, a large number of different irregular shapes may be generated, which may have abundant modulation effects on the incident light, being beneficial to improve the precision of spectral restoration.

The specific structure of the CIS wafer 2 is shown in FIG. 6,wherein the CIS wafer 2 comprises a silicon detector layer 21and a metal wire layer 22, and the response range is the visible near-infrared band; the CIS wafer is bare, and the Bayer optical filter array and micro-lens array are not prepared thereon. Each group of micro-nano structures corresponds to one or more light sensor units on the CIS wafer 2.

The complete process of multi-spectral image acquisition is as follows: as shown in FIG. 16, the broadband spectral light source 100 irradiates the target object 200, and then the reflected light is collected by the spectrum chip 300, or the light directly radiated from the target object is collected by the spectrum chip 300. Each micro-nano structure array and the light sensor underneath form a pixel point. The spectral information on each pixel point may be obtained through the restoration algorithm, and multiple pixels form an image containing spectral information. Both the optical modulation layer 1 and the CIS wafer 2 may be manufactured by the semiconductor CMOS integration process, and monolithic integration is achieved at the wafer level, which is beneficial to reduce the distance between the sensor and the optical modulation layer, reduce the volume of the device, as well as achieve higher spectral resolution and decrease packaging costs.

### Embodiment 2

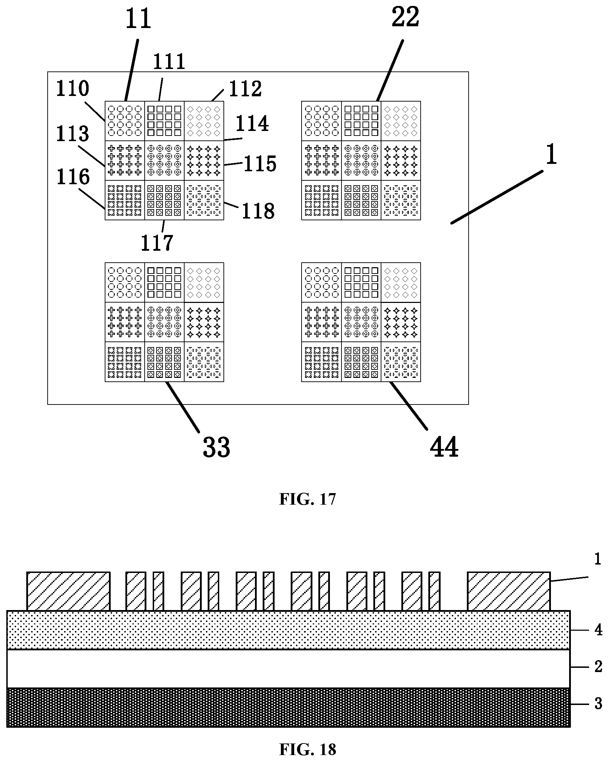

As shown in FIG. 17, the main difference between Embodiment 2 and Embodiment 1 lies in the lateral structure. one or more micro-nano structure units constituting the optical modulation layer 1 have C4 symmetry, that is, after the structure is rotated by 90°, 180° or 270°, it overlaps with the original structure without rotation, which allows the structure to have polarization-independent properties.

### Embodiment 3

As shown in FIG. 18, the main difference between Embodiment 3 and Embodiment 1 lies in the longitudinal structure of the miniature spectrum chip. A light-transmitting medium layer 4 is added between the optical modulation layer 1 and the CIS wafer 2. The light-transmitting medium layer 4 has a thickness of 50 nm to 2 µm, and the material may be silicon dioxide. If the process solution of direct deposition growth is applied, the light-transmitting medium layer may be prepared by chemical vapor deposition, sputtering, and spin coating on CIS wafers, followed by the deposition and etching of the optical modulation layer structure on top of it. If the process solution of transfer is applied, the micro-nano structure may be prepared on the silicon dioxide first, and then the micro-nano structure and silicon dioxide may be transferred to the CIS wafer as a whole. It is possible to prepare the spectrum chip by the CMOS process in a single flow, which is beneficial to reduce the failure rate of the device, improve the yield of the device, and decrease the cost.

### Embodiment 4

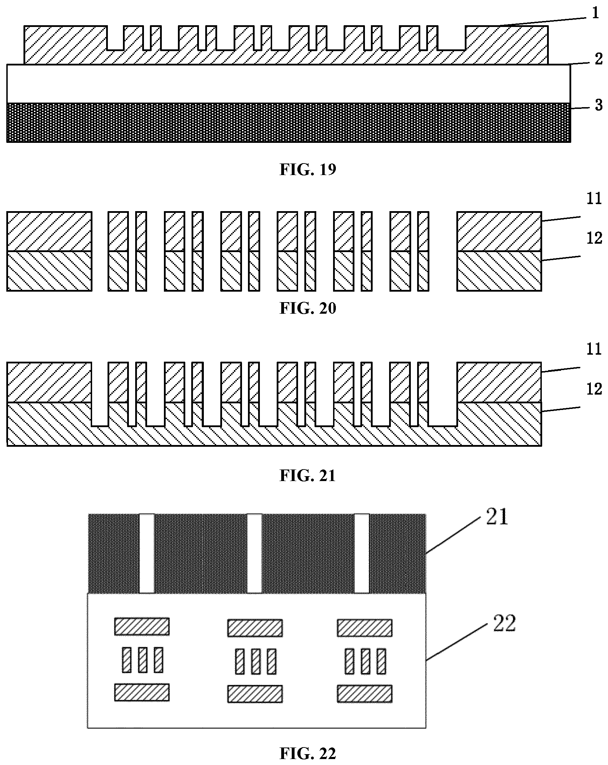

As shown in FIG. 19, the difference between Embodiment 4 and Embodiment 1 is that the grating in the optical modulation layer 1 is a partially etched structure, and the holes therein do not completely penetrate the plate, but have a certain depth. The thickness of the micro-nano structure is 50 nm to 2 µm, and the thickness of the entire plate is 100 nm to 4 µm; and a light-transmitting medium layer may be added between layer 1 and layer 2 of this structure.

### Embodiment 5

As shown in FIG. 20, the difference between Embodiment 5 and Embodiment 1 is that the optical modulation layer 1 has a double-layer structure, layer 11 is a silicon layer, layer 12 is a silicon nitride layer, and the thickness of the double-layer structure is 50 nm to 2 µm; and, the lower layer material of this structure can also be a partially etched structure that is not penetrated, as shown in FIG. 21.

### Embodiment 6

As shown in FIG. 22, the difference between Embodiment 6 and Embodiment 1 is that the CIS wafer is back-side illuminated, and the optical detection layer 21 is above the metal wire layer 22, which reduces the influence of the metal wire layer on incident light and improves the quantum efficiency of the device.

### Embodiment 7

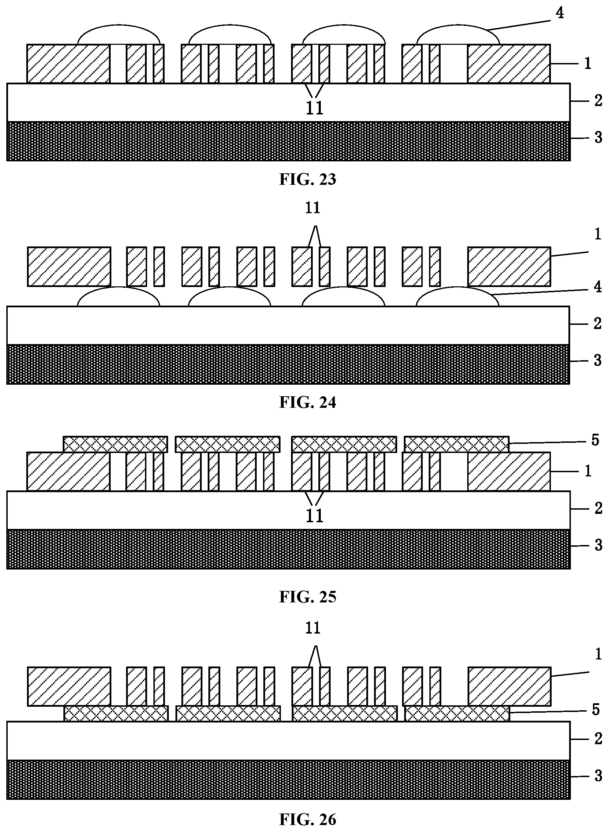

The difference between Embodiment 7 and Embodiment 1 is that the spectrum chip integrates micro-lens or light filter or both. As shown in FIGS. 23 and 24, the spectrum chip integrates a micro-lens 4, which can be disposed above (FIG. 23) or below (FIG. 24) the optical modulation layer; as shown in FIGS. 25 and 26, the spectrum chip integrates an optical filter 5, which may be disposed above (FIG. 25) or below (FIG. 26) the optical modulation layer; as shown in FIGS. 27 and 28, the spectrum chip integrates the micro-lens 4 and the optical filter 5, which can be disposed above (FIG. 27) or below (FIG. 28) the optical modulation layer.

An embodiment of the present application provides a method for generating micro-nano structure arrays in a spectrum chip. The embodiment of the present application is intended to generate a random-shaped structure in a random way, so that a two-dimensional grating structure based on the random-shaped structure has rich broadband spectral modulation effects on incident light, which is conducive to improving the precision of spectral restoration. In an embodiment, the random way for generating the random-shaped structures can be an algorithm or can be a combination of artificial adjustment and algorithm, For example, the random-shaped structures can be generated by algorithm first and then adjusted artificially. The present application will be explained with an example of generating the random-shaped structures by algorithm randomly.

FIG. 31 is a schematic structural diagram of a spectrum chip according to an embodiment of the present application. As shown in FIG. 31, the spectrum chip includes a wafer-level image sensor 2, where an upper surface of a photosensitive area of the wafer-level image sensor 2 is provided with an optical modulation layer 1; the optical modulation layer 1 includes a unit array formed of a plurality of micro-nano units 4, each of the micro-nano units 4 corresponds to one or more pixel points on the wafer-level image sensor 2; the micro-nano unit 4 includes multiple groups of micro-nano structure arrays, each group of the micro-nano structure arrays is formed in a two-dimensional grating structure, and the two-dimensional grating structures in the plurality of groups of micro-nano structure arrays of each of the micro-nano unit 4 are used for modulating an incident light, and encoding a spectral information of the incident light to different pixel points of the wafer-level image sensor 2 to obtain an image including the spectral information of the incident light.

In an embodiment, the method for generating micro-nano structure arrays in a spectrum chip includes a step of generating the two-dimensional grating structure, where the two-dimensional grating structure is formed by periodically arranging random-shaped structures. In an embodiment, the random-shaped structures in the same group of micro-nano structure array can be the same or different, and the random-shaped structures in different groups of micro-nano structure arrays can be the same or different.

In an embodiment, the step of generating the two-dimensional grating structure includes:
determining an arrangement period of the random-shaped structures in the two-dimensional grating structure;
generating each random-shaped structure 5 in the two-dimensional grating structure according to the following processing procedure:
   meshing an area within the arrangement period to obtain a plurality of mesh areas;
   assigning pixel values to the plurality of mesh areas randomly to obtain an initial pattern corresponding to the random-shaped structure, where mesh areas corresponding to different pixel values have different refractive indexes; and
   binarizing the initial pattern to obtain a first binarized pattern, where the first binarized pattern corresponds to one random-shaped structure 5, 0 and 1 in the first binarized pattern represent air and a medium, respectively. In an embodiment, the initial pattern can be filtered and smoothed before being binarized, to make the contour of the obtained random-shaped structure smoother.

The method for generating micro-nano structure arrays in a spectrum chip according to the embodiment of the present application is described below. The present application is intended to generate a random-shaped structure in a random way, so that a two-dimensional grating structure based on the random-shaped structure has abundant broadband spectral modulation effects on incident light, which is conducive to improving the precision of spectral restoration.

In an embodiment, the structural diagram of the spectrum chip is shown as FIG. 31. The spectrum chip includes the wafer-level image sensor 2, where the upper surface of the photosensitive area of the wafer-level image sensor 2 is provided with the optical modulation layer 1. For example, one or more layers of medium or metal material can be directly grown on the photosensitive area of the wafer-level image sensor 2, and then the optical modulation layer 1 can be obtained by etching and preparing the one or more layers of medium or metal material.

In an embodiment, the wafer-level image sensor 2 can be implemented using CIS wafer.

In an embodiment, the optical modulation layer 1 includes a unit array formed of a plurality of micro-nano units 4. Each of the micro-nano units 4 corresponds to one or more pixel points on the wafer-level image sensor in vertical direction. The micro-nano unit 4 includes multiple groups of micro-nano structure arrays. Each group of micro-nano structure arrays is formed by two-dimensional grating structures. After passing through the optical modulation layer 1, the incident light is modulated by the two-dimensional grating structures in the plurality of groups of micro-nano structure arrays of each micro-nano unit 4. Intensity of the modulated light signal is detected by the wafer-level image sensor 2 and converted into electrical signal.

In an embodiment, after the incident light passes through the optical modulation layer 1, the two-dimensional grating structure on the optical modulation layer 1 modulates the incident light and encodes the spectral information of the incident light to different pixel points of the wafer-level image sensor to obtain an image including the spectral information of the incident light. For example, after passing through the optical modulation layer 1, the incident light is converted into an electrical signal by the wafer-level image sensor 2 to form an image including the spectral information of the incident light, and then the image including the spectral information of the incident light is processed by a signal processing circuit connected with the wafer-level image sensor 2 to obtain the spectral information of the incident light.

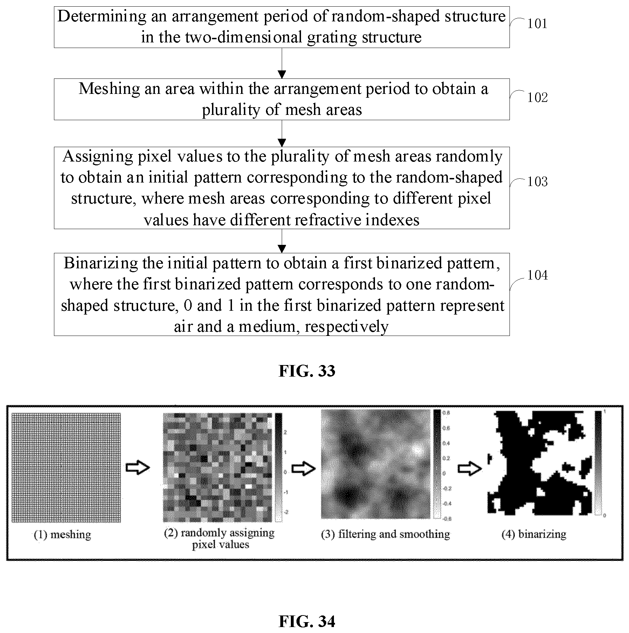

FIG. 33 is a schematic flow chart of generating a two-dimensional grating structure according to an embodiment of the present application. As shown in FIG. 33, the generating a two-dimensional grating structure according to an embodiment of the present application includes the following steps.

Step 101: determining an arrangement period of random-shaped structure in the two-dimensional grating structure.

In an embodiment, in step 101, the determining the arrangement period of the random-shaped structure in the two-dimensional grating structure is intended to guide step 102 to mesh an area within a period. For example, if the arrangement period is 300 nm, the area within 300 nm is meshed.

Each random-shaped structure in the two-dimensional grating structure is generated according to the processing procedure from step 102 to step 104.

Step 102: meshing an area within the arrangement period to obtain a plurality of mesh areas.

In step 102, refer to (1) of FIG. 5, the area within the arrangement period is meshed. For example, meshes of 100*100 are obtained by meshing an area within one period. It should be noted that the size of the mesh can be set flexibly. The smaller the grid, the smoother the edges of the obtained random-shaped structure.

Step 103: assigning pixel values to the plurality of mesh areas randomly to obtain an initial pattern corresponding to the random-shaped structure, where mesh areas corresponding to different pixel values have different refractive indexes.

In step 103, pixel values are assigned to the plurality of mesh areas randomly to obtain the initial pattern corresponding to the random-shaped structure (as shown in (2) of FIG. 34). Referring to (2) of FIG. 34, the color gradations of different mesh areas correspond to different pixel values. The corresponding refractive indexes are assigned according to the pixel values, so that mesh areas with different pixel values have different refractive indexes. Since the pixel values are randomly assigned to the plurality of mesh areas, the assignment of the refractive indexes is also random. It should be noted that the assigned refractive index in this step only represents a numerical value and does not represent the refractive index of real materials.

Step 104: binarizing the initial pattern to obtain a first binarized pattern, where the first binarized pattern corresponds to one random-shaped structure, 0 and 1 in the first binarized pattern represent air and a medium, respectively. In an embodiment, the initial pattern can be filtered and smoothed before being binarized, to make the contour of the obtained random-shaped structure more smooth.

For example, in step 104, the initial pattern (as shown in (2) of FIG. 34) is filtered and smoothed to obtain a pattern (as shown in (3) of FIG. 34), and the pattern is binarized (as shown in (3) of FIG. 34) to obtain the first binarized pattern (as shown in (4) of FIG. 34). In this step, it should be noted that, the binarizing the initial pattern can be performed by taking all areas whose refractive indexes are greater than a threshold value as 1, and taking all areas whose refractive indexes are less than the threshold value as 0. In this way, there are only two values 0 and 1 in the refractive index distribution, where 0 represents air and 1 represents medium. In this step, since the initial pattern is obtained by randomly assigning pixel values to the plurality of mesh areas, a random-shaped structure can be generated.

In an embodiment, after obtaining the first binarized pattern, corresponding medium can be etched from the first binarized pattern based on the distribution of air and medium on the first binarized pattern, and thus the corresponding random-shaped structure can be obtained.

In an embodiment, referring to the schematic sectional view of a spectrum chip according to FIG. 32, each group of micro-nano structure arrays on the spectral modulation layer is formed based on the two-dimensional grating structure. By changing the random-shaped structures 5 of the two-dimensional grating structures, the micro-nano structure arrays have different modulation effects on the incident light in target wave band.

In the method for generating micro-nano structure array in spectrum chip according to the embodiments of the present application, the area within the arrangement period is meshed to obtain a plurality of mesh areas, the pixel values are randomly assigned to the plurality of mesh areas to obtain the initial pattern, and then the initial pattern is filtered and smoothed and then binarized to obtain random-shaped structure. Since each group of micro-nano structure arrays, namely each two-dimensional grating structure, is formed of the random-shaped structures generated in such a random way, the optical modulation layer including multiple groups of micro-nano structure arrays includes a variety of random-shaped structures. Therefore, the optical modulation layer has abundant broadband spectral modulation effects on incident light, which is conducive to overcoming the limitation to precision of spectral restoration to obtain high-precision measurement for the incident light spectrum and to improve the precision of spectral restoration.

On the basis of the above embodiments, in an embodiment, after obtaining the first binarized pattern, the method further includes:
fuzzifying and binarizing the first binarized pattern sequentially to obtain a second binarized pattern, where the second binarized pattern corresponds to a random-shaped structure.

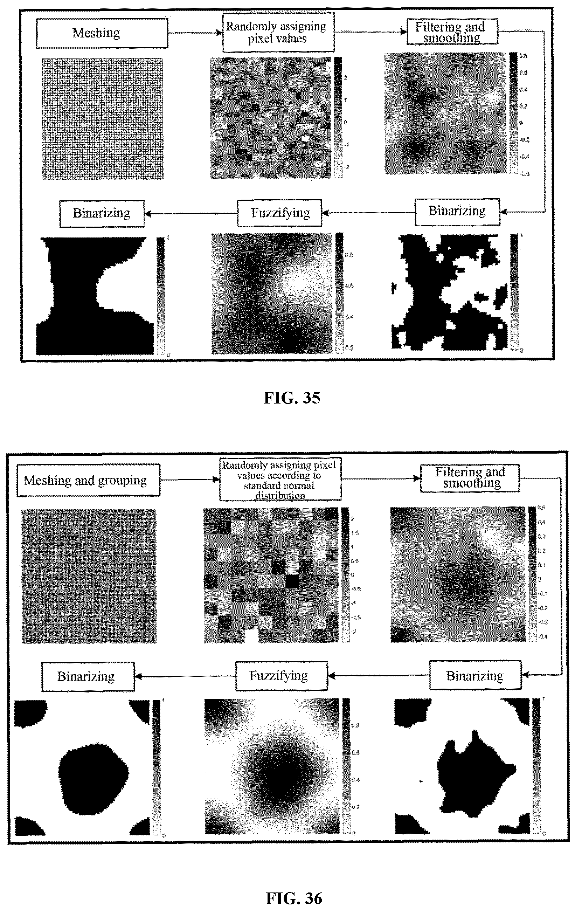

In this embodiment, as shown in FIG. 35, after the first binarized pattern is obtained, in order to eliminate some random-shaped structures with too small size to facilitate processing, the first binarized pattern is fuzzified and binarized sequentially to generate the second binarized pattern. The second binarized pattern corresponds to a random-shaped structure, and the random-shaped structure corresponding to the second binarized pattern includes no structure with too small size, which is convenient for processing.

In an embodiment, some random-shaped structures with too small size and/or too large size can be directly selected by means of algorithms and can be eliminated to facilitate processing.

On the basis of the above embodiments, in an embodiment, the assigning pixel values to the plurality of mesh areas randomly to obtain the initial pattern corresponding to the random-shaped structure includes:
grouping the plurality of mesh areas to obtain multiple groups of meshes, where one or more mesh areas constitute one group when the plurality of mesh areas are grouped; and
assigning the pixel values to each group of meshes randomly according to a standard normal distribution to obtain the initial pattern corresponding to the random-shaped structure, where the mesh areas in one group have the same pixel values.

In this embodiment, as shown in FIG. 36, for example, the arrangement period of random-shaped structure in two-dimensional grating structure is determined to be 300 nm, meshes of 100*100 are meshed within one period for grouping (for example, grouping is performed according to meshes of 10* 10, that is, 10 meshes form to one large mesh), and the pixel values are randomly assigned to each group of meshes according to the standard normal distribution to obtain the initial pattern corresponding to the random-shaped structure (as shown in the dotted box in FIG. 36).

It can be seen from the above solutions that in the method for generating micro-nano structure arrays in a spectrum chip according to the embodiments of the present application, the pixel values are randomly assigned to each group of meshes according to the standard normal distribution, so that the pixel values of each mesh area in one group are the same, and thus the same random-shaped structure can be obtained.

On the basis of the above embodiments, in an embodiment, when generating the random-shaped structures in two-dimensional grating structure, one or more of the meshing parameter corresponding to the meshing operation, the random assignment parameter corresponding to the pixel value random assignment operation, the filtering and smoothing parameter corresponding to the filtering and smoothing operation, and the fuzzification parameter corresponding to the fuzzification operation are controlled to make that the minimum size of the random-shaped structure is greater than a preset threshold value and the ratio of medium to air in the random-shaped structure satisfies a preset constraint condition. Further, in other embodiments, the minimum size of the random-shaped structure can be controlled to be greater than the preset threshold value and the ratio of medium to air in the random-shaped structure can be controlled to satisfy the preset constraint condition by this way.

In an embodiment, random-shaped structures whose minimum feature size is greater than the preset threshold value can be generated by adjusting the algorithm parameters, such as one or more of the mesh division parameter, the random assignment parameter, the filtering and smoothing parameter, and the fuzzification parameter. For example, the minimum feature size of the generated random-shaped structure is greater than 30 nm. In addition, the algorithm parameters can be adjusted to control the ratio of medium to air in a random-shaped structure within a specific range. For example, the proportion of medium area is 20%~80%, so as to satisfy the constraint condition.

It can be seen from the above solutions that in the method for generating micro-nano structure array in spectrum chip according to the embodiments of the present application, the generated random-shaped structure can be specifically restricted by adjusting algorithm parameters, such as the meshing parameter, the random assignment parameter, the filtering and smoothing parameter, and the fuzzification parameter, etc., and the minimum feature size of the generated random shape can be controlled to meet the precision requirements for process preparation, so as to reduce the difficulty in preparation. In an embodiment, the size of the random-shaped structure can be decreased easily by controlling the relevant processing parameters in the process of generating the random-shaped structure, and thus the volume and cost of the spectrum chip can be reduced conveniently.

In an embodiment, the random shapes generated by using algorithms have more abundant curvature variations than the regular shapes, such as round, square, cross, and so on. In an embodiment, the shapes generated by using algorithms have two or more different curvatures, which can improve the light modulation effect. An example is given to define different curvatures: a circular includes one specific curvature, while a sector includes three curvatures which are a curvature of 0 (straight line), a curvature of infinity (vertex) and a curvature with a specific value (arc). It should be noted that the more abundant the curvatures of the structures, the more obvious the effect of scattering, refraction and the like on the incident light, thus making the light modulation effect better. In an embodiment, the number of curvatures included in the internal unit with a random shape according to the present application can be 2, 3, 4, 5 or more.

On the basis of the above embodiments, in an embodiment, after obtaining the first binarized pattern or the second binarized pattern, the method further includes: performing symmetry processing on the first binarized pattern or the second binarized pattern to obtain a pattern with symmetry, where the pattern with symmetry corresponds to a random-shaped structure.

In an embodiment, the symmetry processing includes one or more of the following items: two-fold rotational symmetry processing, Y-axis mirror symmetry processing, X-axis mirror symmetry processing, both Y-axis and X-axis mirror symmetry processing, four-fold rotational symmetry processing, or both Y-axis and X-axis mirror symmetry and four-fold rotational symmetry processing.

Accordingly, the obtained pattern with symmetry includes one or more of the following items: a pattern with two-fold rotational symmetry, a pattern with Y-axis mirror symmetry, a pattern with X-axis mirror symmetry, a pattern with both Y-axis and X-axis mirror symmetry, a pattern with four-fold rotational symmetry, or a pattern with both Y-axis and X-axis mirror symmetry and four-fold rotational symmetry.

In an embodiment, after obtaining the first binarized pattern or the second binarized pattern, symmetry processing can be performed on the first binarized pattern or the second binarized pattern by using the corresponding symmetry processing functions to obtain the pattern with symmetry. In this embodiment, different symmetry processing needs different symmetry processing function. For example, the two-fold rotational symmetry processing can be completed by two-fold rotational symmetry processing functions. That is, the obtained first binarized pattern or the second binarized pattern can be processed by the two-fold rotational symmetry processing functions to obtain the pattern with two-fold rotational symmetry. In an embodiment, in order to simplify the processing, the above processing can be performed in MATLAB. For example, in the MATLAB software, a corresponding symmetry processing function can be called to perform the symmetry processing on the first binarized pattern or the second binarized pattern. For example, if a four-fold rotational symmetry processing needs to be performed on the first binarized pattern or the second binarized pattern, the four-fold rotational symmetry processing function can be called to obtain a pattern with four-fold rotational symmetry. Similarly, if Y-axis mirror symmetry processing needs to be performed on the first binarized pattern or the second binarized pattern, a Y-axis mirror symmetry processing function can be called to obtain a pattern with Y-axis mirror symmetry.

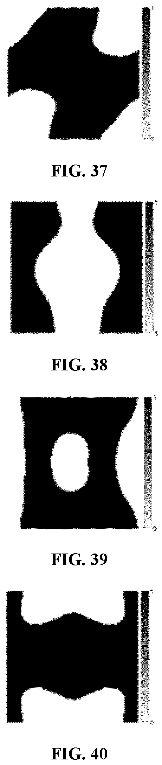

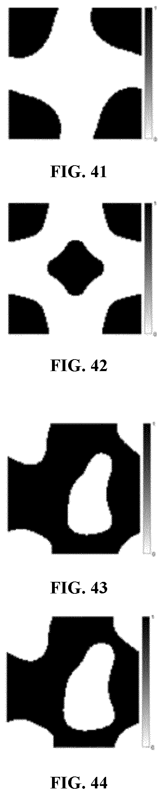

In an embodiment, referring to FIG. 37 to FIG. 42, a symmetry restriction is imposed on the first binarized pattern or the second binarized pattern. For example, as shown in FIG. 37, a pattern with two-fold rotational symmetry is obtained by performing the two-fold rotational symmetry processing; as shown in FIG. 38, a pattern with Y-axis mirror symmetry is obtained by performing the Y-axis mirror symmetry processing; as shown in FIG. 39, a pattern with X-axis mirror symmetry is obtained by performing the X-axis mirror symmetry processing; as shown in FIG. 40, a pattern with both Y-axis and X-axis mirror symmetry is obtained by performing the both Y-axis and X-axis mirror symmetry processing; as shown in FIG. 41, a pattern with four-fold rotational symmetry is obtained by performing the four-fold rotational symmetry processing; and as shown in FIG. 42, a pattern with both Y-axis and X-axis mirror symmetry and four-fold rotational symmetry is obtained by performing the both Y-axis and X-axis mirror symmetry and four-fold rotational symmetry processing.

In an embodiment, in order to make the two-dimensional grating structure in the micro-nano structure array have a polarization independent characteristic, the four-fold rotational symmetry processing can be performed on the first binarized pattern or the second binarized pattern to obtain the pattern with four-fold rotational symmetry. It should be noted that the optical modulation layer is insensitive to the polarization of the incident light since the two-dimensional grating structure in the micro-nano structure array has four-fold rotational symmetry.

It should be noted that the traditional spectrometer needs to separate the different wavelengths of the incident light through the spectroscopic components, and then detect them, where the spectroscopic components generally has different responses to the incident light with different angles and polarizations. In actual practice, since the incident angle and polarization characteristic of the light to be measured cannot be obtained in advance, the traditional spectrometer is generally equipped with additional collimator and polarizer, which not only increases the volume and cost of the device, but also reduces the working stability of the device. Therefore, a spectral device being insensitive to both incident angle and polarization has a great significance in actual practice. In view of this, an embodiment of the present application provides a spectrum chip, and a random-shaped structure with four-fold rotational symmetry can be obtained by performing the four-fold rotational symmetry processing on the first binarized pattern or the second binarized pattern obtained during generating the micro-nano structure array in the spectrum chip, so that the spectrum chip can measure the spectral information of the incident light regardless of the incident angle and the polarization characteristic of the incident light to a certain extent, that is, the spectrum chip is insensitive to the incident angle and the polarization, and the spectral measurement result will not be affected by the incident angle and polarization characteristic of the light to be measured, thereby ensuring the stability of the spectral measurement performance. In an embodiment, in the spectrum chip according to the embodiments of the present application, the optical modulation layer insensitive to the incident angle and polarization and the wafer-level image sensor are integrated in a monolithic integration manner without discrete component and without an additional need for complex optical components, such as collimator and polarizer, which is conducive to improving the stability of the device and reducing the volume and cost of the device.

It can be seen from the above solutions that in the method for generating micro-nano structure array in spectrum chip according to the embodiments of the present application, the generated random-shaped structure can satisfy different symmetry requirements by imposing symmetry restriction on the binarized pattern.

On the basis of the above embodiments, in an embodiment, after obtaining the first binarized pattern or the second binarized pattern, the method further includes: dilating or eroding the first binarized pattern or the second binarized pattern, to simulate insufficient or excessive etching in the process preparation.

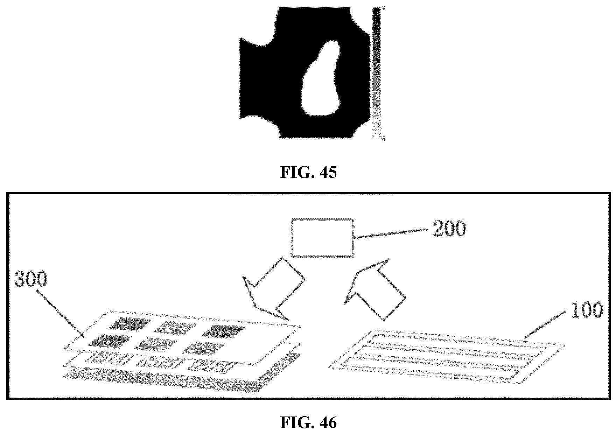

In an embodiment, referring to FIG. 43 to FIG. 45, the first binarized pattern or the second binarized pattern is dilated or eroded. FIG. 43 shows a binarized pattern with a random shape. FIG. 44 shows a binarized pattern with a random shape after eroding this binarized pattern, for example, eroding the medium area of this binarized pattern by 10 nm. FIG. 45 shows a binarized pattern with a random shape after dilating this binarized pattern, for example, dilating the medium area of this binarized pattern by 10 nm.

It can be seen from the above solutions that in the method for generating micro-nano structure array in spectrum chip according to the embodiments of the present application, it can simulate the situation of insufficient or excessive etching in the process preparation. The effect of insufficient or excessive etching on the spectral characteristic of the structure can be analyzed through subsequent electromagnetic simulation, which is convenient for analyzing the anti process error characteristic of the structure, and thus the random-shaped structures with good anti process error characteristic can be selected.

On the basis of the above embodiments, in an embodiment, the spectrum chip further includes: a signal processing circuit 3 connected with the wafer-level image sensor 2;
where the signal processing circuit 3 is used for processing an image including the spectral information of the incident light to obtain the spectral information of the incident light.

In an embodiment, the optical modulation layer includes a plurality of repeating units, and the signal processing circuit corresponding to each unit can restore the spectral information corresponding to this unit. The input of the signal processing circuit is the light intensity signal detected by each photosensitive pixel of the CIS wafer. By using the light intensity values and combining with a transmission spectrum of each group of micro-nano structure arrays measured in advance, the spectral information of the input light can be restored through corresponding algorithms. In actual practice, the image including the spectral information of the incident light can be processed by different algorithms according to the requirements, so as to obtain the spectral information of the incident light.

In an embodiment, a complete process of collecting multi-spectral image is as follows: as shown in FIG. 46, a broadband spectral light source 100 from visible light to near-infrared light illuminates a target object 200, and then a reflected light is collected by a spectrum chip 300, or the light radiated from the target object is collected by the spectrum chip 300. Each unit and a light sensor below the unit form a pixel point, a spectral information corresponding to each pixel point can be obtained through a restoration algorithm, and a plurality of pixel points form an image including spectral information. Both the optical modulation layer 1 and the wafer-level image sensor 2 can be manufactured by semiconductor CMOS integration process and can be integrated in a monolithic integration manner at wafer level, which is conducive to reducing the distance between the sensor and the optical modulation layer, reducing the volume of the device, achieving higher spectral resolution and decreasing the packaging cost.

In an embodiment, referring to FIG. 31, the spectrum chip further includes: a signal processing circuit 3 connected with the wafer-level image sensor 2, where an image including the spectral information of the incident light is processed by the signal processing circuit 3 to restore the spectral information of the incident light.

On the basis of the above embodiments, in an embodiment, a light-transmitting medium layer is provided between the optical modulation layer 1 and the wafer-level image sensor 2.

It should be noted that by arranging the light-transmitting medium layer between the optical modulation layer and the wafer-level image sensor, the optical modulation layer and the wafer-level image sensor can be effectively separated, which can avoid a mutual interference between them.

In an embodiment, the light-transmitting medium layer can have a thickness of 50 nm to 1 µm, and can be made of silicon dioxide. In case that a process scheme of directly growing by deposition is applied, the light-transmitting medium layer can be prepared on the wafer-level image sensor by chemical vapor deposition, sputtering, spin coating and other methods, followed by depositing and etching the optical modulation layer structure above the light-transmitting medium layer. In case that a process scheme of transfer is applied, the micro-nano structure can be prepared on silicon dioxide first, and then the silicon dioxide including the micro-nano structure can be transferred to the wafer-level image sensor.

On the basis of the above embodiments, in an embodiment, the wafer-level image sensor 2 is front-side illuminated, including: a metal wire layer and an optical detection layer arranged from up to down, and the optical modulation layer 1 is integrated on a side of the metal wire layer distal to the optical detection layer; or
the wafer-level image sensor 2 is back-side illuminated, including: an optical detection layer and a metal wire layer arranged from up to down, and the optical modulation layer 1 is integrated on a side of the optical detection layer distal to the metal wire layer.

It should be noted that for the back-side illuminated wafer-level image sensor, the optical detection layer is above the metal wire layer, which can reduce the impact from the metal wire layer on the incident light, thus improving the quantum efficiency of the device.

On the basis of the above embodiments, in an embodiment, the spectrum chip further includes: micro-lens and/or optical filters;
the micro-lens is arranged on a side of the optical modulation layer 1 distal to the wafer-level image sensor 2, or the micro-lens is arranged on a side of the optical modulation layer 1 proximal to the wafer-level image sensor 2; and
the light filter is arranged on the side of the optical modulation layer 1 distal to the wafer-level image sensor 2, or the light filter is arranged on the side of the optical modulation layer 1 proximal to the wafer-level image sensor 2.

In addition, in the present application, the terms, such as "first" and "second", are only used for description purposes, and cannot be understood as indicating or implying relative importance or implying the number of indicated features. The features defined as "first" and "second" can explicitly or implicitly include one or more such features. In the description of the present application, "multiple" or "a plurality of" means two or more, such as two, three, etc., unless otherwise specifically defined.

Furthermore, in the present application, the relational terms, such as first and second, are only used to distinguish one entity or operation from another, and do not necessarily require or imply any such actual relationship or order between these entities or operations. Moreover, the terms "including", "comprising" or any other variant thereof are intended to cover non-exclusive inclusion, so that a process, method, object or device including a series of elements not only includes those elements, but also includes other elements not explicitly listed, or also includes elements inherent to such process, method, object or device. Without more restrictions, the elements defined by the statement "including a ...", or "including one ...", or the similar do not exclude that there are other identical elements in the process, method, object or device including these elements.

In addition, in the description of the specification of the present application, reference terms, such as "an embodiment", "some embodiments", "example", "specific example", or "some examples", mean that the feature, structure, material, or characteristic described in combination with this embodiment or example are included in one or more embodiments or examples of the present application. In this specification, the illustrative expression of the above terms need not refer to the same embodiments or examples. Furthermore, the described feature, structure, material, or characteristic can be combined in an appropriate manner in any one or more embodiments or examples. In addition, those skilled in the art can combine different embodiments or examples described in this specification and the features in different embodiments or examples without contradiction.

The above description only illustrates the preferred embodiments of the present application and is a description of the principles employed. It should be understood by those skilled in the art that the scope of the disclosure covered by the present application is not limited to the solution formed by a particular combination of the above features, but should also cover other solutions formed by any combination of the above features or their equivalent features without departing from the above disclosed idea. For example, the solutions formed by interchanging the above features with the features with similar functions disclosed in the present application (but not limited to) also fall within the scope of the present application.

## Claims

1. A micro spectrum chip based on units of different shapes, comprising a CMOS image sensor, CIS, wafer (2) and an optical modulation layer (1);
wherein the optical modulation layer (1) comprises one or more micro-nano structure units (11, 22, 33, 44, 55, 66) provided on a surface of a photosensitive area of the CIS wafer (2), each micro-nano structure unit (11, 22, 33, 44, 55, 66) comprises one or more micro-nano structure arrays, the micro-nano structure arrays in at least one of the one or more micro-nano structure units (11, 22, 33, 44, 55, 66) are two-dimensional gratings (111, 112, 113, 440, 442, 443, 444) formed of internal units of different shapes, and the micro-nano structure array in at least one of the one or more micro-nano structure units is two-dimensional grating formed of internal units of random shapes, and the internal units of random shapes comprise two or more curvatures.

2. The micro spectrum chip of claim 1, wherein each of the one or more micro-nano structure arrays is a two-dimensional grating formed of internal units of different shapes.

3. The micro spectrum chip of claim 1, wherein the one or more micro-nano structure units are identical repeating units, the micro-nano structure arrays located at corresponding positions in different micro-nano structure units are identical, and/or no micro-nano structure array exists at one or more corresponding positions in different micro-nano structure units, and/or, each of the micro-nano structure units has a size of 0.5 µm² to 40000 µm², and/or, each of the micro-nano structure arrays has a period of 20 nm to 50 µm.

4. The micro spectrum chip of claim 1, wherein a number of micro-nano structure arrays in each of the micro-nano structure units is dynamically adjustable; and/or, the one or more micro-nano structure units have C4 symmetry.

5. The micro spectrum chip of claim 1, wherein each of the micro-nano structure arrays corresponds to one or more pixels on the CIS wafer (2).

6. The micro spectrum chip of any one of claims 1 to 5, further comprising a signal processing circuit (3) connected to the CIS wafer (2) through electrical contact.

7. The micro spectrum chip of claim 1, wherein the CIS wafer (2) comprises an optical detection layer (21) and a metal wire layer (22), wherein the optical detection layer (21) is provided under the metal wire layer (22) and the optical modulation layer (1) is integrated on the metal wire layer (22); or the optical detection layer (21) is provided above the metal wire layer (22) and the optical modulation layer (1) is integrated on the optical detection layer;
wherein when the optical detection layer (21) is provided above the metal wire layer (22), the optical modulation layer (1) is prepared by etching the optical detection layer (21) of the CIS wafer (2) with an etching depth of 50 nm to 2 µm.

8. The micro spectrum chip of claim 1, wherein the optical modulation layer (1) is single-layer structure, double-layer structure or multi-layer structure and a thickness of each layer is 50 nm to 2 µm; the optical modulation layer is made of one or more of the following items: silicon, germanium, silicon-germanium material, silicon compound, germanium compound, metal, or III-V group material, and wherein the silicon compound comprises silicon nitride, silicon dioxide, and/or silicon carbide, and/or, when the optical modulation layer is double-layer structure or multi-layer structure, one or more of the layers is not penetrated through.

9. The micro spectrum chip of claim 1, wherein a light-transmitting medium layer (4) is provided between the optical modulation layer (1) and the CIS wafer (2), the light-transmitting medium layer has a thickness of 50 nm to 2 µm, and the light-transmitting medium layer (4) comprises silicon dioxide; the light-transmitting medium layer (4) is prepared on the CIS wafer by chemical vapor deposition, sputtering or spin coating, and then the optical modulation layer (1) is deposited and etched on the light-transmitting medium layer (4); or the optical modulation layer (1) is prepared on the light-transmitting medium layer (4), and then the light-transmitting medium layer (4) and the optical modulation layer (1) are transferred to the CIS wafer (2) ;
wherein the micro spectrum chip comprises a micro-lens and/or an optical filter, and the micro-lens and/or the light filter are provided above or below the optical modulation layer.

10. A method for generating micro-nano structure array in spectrum chip as recited in claim 1, wherein the spectrum chip comprises a wafer-level image sensor (2), and an upper surface of a photosensitive area of the wafer-level image sensor is provided with an optical modulation layer (1); the optical modulation layer (1) comprises a unit array formed of a plurality of micro-nano units (4), and each of the micro-nano units corresponds to one or more pixel points on the wafer-level image sensor; and the micro-nano unit comprises multiple groups of micro-nano structure arrays, each group of the micro-nano structure arrays is formed in a two-dimensional grating structure, and the two-dimensional grating structure in the multiple groups of micro-nano structure arrays of each micro-nano unit is used for modulating an incident light and encoding spectral information of the incident light to different pixel points of the wafer-level image sensor to obtain an image including the spectral information of the incident light;
wherein the method for generating micro-nano structure arrays in a spectrum chip comprises: generating the two-dimensional grating structure, the two-dimensional grating structure being formed by periodically arranging random-shaped structures; and
the generating the two-dimensional grating structure comprises:
step 101, determining an arrangement period of the random-shaped structures in the two-dimensional grating structure;
generating each of the random-shaped structures in the two-dimensional grating structure by the following steps:
step 102, meshing an area within the arrangement period to obtain a plurality of mesh areas;
step 103, assigning pixel values to the plurality of mesh areas randomly to obtain an initial pattern corresponding to the random-shaped structure, wherein mesh areas corresponding to different pixel values have different refractive indexes; and
step 104, binarizing the initial pattern to obtain a first binarized pattern, wherein the first binarized pattern corresponds to one of the random-shaped structures, 0 and 1 in the first binarized pattern represent air and a medium, respectively.

11. The method of claim 10, wherein before being binarized, the initial pattern is filtered and smoothed in advance;
after obtaining the first binarized pattern, further comprising:
fuzzifying and binarizing the first binarized pattern sequentially to obtain a second binarized pattern, wherein the second binarized pattern corresponds to one random-shaped structure;
wherein the assigning pixel values to the plurality of mesh areas randomly to obtain the initial pattern corresponding to the random-shaped structure comprises:
grouping the plurality of mesh areas to obtain multiple groups of meshes, wherein one or more mesh areas constitute one group when the plurality of mesh areas are grouped; and
assigning the pixel values to each group of meshes randomly according to a standard normal distribution to obtain the initial pattern corresponding to the random-shaped structure, wherein the mesh areas in one group have the same pixel value.

12. The method of any one of claims 10 to 11, wherein after obtaining the first binarized pattern or the second binarized pattern, further comprising:
performing symmetry processing on the first binarized pattern or the second binarized pattern to obtain a pattern with symmetry, wherein the pattern with symmetry corresponds to one of the random-shaped structures;
wherein the symmetry processing comprises one or more of the following items: two-fold rotational symmetry processing, Y-axis mirror symmetry processing, X-axis mirror symmetry processing, both Y-axis and X-axis mirror symmetry processing, four-fold rotational symmetry processing, or both Y-axis and X-axis mirror symmetry and four-fold rotational symmetry processing;
the pattern with symmetry comprises one or more of the following items:
a pattern with two-fold rotational symmetry, a pattern with Y-axis mirror symmetry, a pattern with X-axis mirror symmetry, a pattern with both Y-axis and X-axis mirror symmetry, a pattern with four-fold rotational symmetry, or a pattern with both Y-axis and X-axis mirror symmetry and four-fold rotational symmetry.

13. The method of any one of claims 10 to 11, after obtaining the first binarized pattern or the second binarized pattern, further comprising: dilating or eroding the first binarized pattern or the second binarized pattern to simulate insufficient or excessive etching in the process preparation.

14. The method of claim 11, wherein the spectrum chip further comprises: micro-lens and/or optical filter;
the micro-lens is arranged on a side of the optical modulation layer (1) distal to the wafer-level image sensor (2), or the micro-lens is arranged on a side of the optical modulation layer (1) proximal to the wafer-level image sensor (2); and
the light filter is arranged on the side of the optical modulation layer (1) distal to the wafer-level image sensor (2), or the light filter is arranged on the side of the optical modulation layer (1) proximal to the wafer-level image sensor (2).

## Patentansprüche

1. Mikrospektrumchip auf der Basis von Einheiten unterschiedlicher Formen, der einen CMOS-Bildsensor-Wafer (CMOS image sensor wafer, CIS-Wafer) (2) und eine optische Modulationsschicht (1) umfasst,
wobei die optische Modulationsschicht (1) eine oder mehrere Mikro-Nano-Struktur-Einheiten (11, 22, 33, 44, 55, 66) umfasst, die auf einer Fläche eines lichtempfindlichen Bereichs des CIS-Wafers (2) bereitgestellt sind, jede Mikro-Nano-Struktur-Einheit (11, 22, 33, 44, 55, 66) ein oder mehrere Mikro-Nano-Struktur-Arrays umfasst, die Mikro-Nano-Struktur-Arrays in mindestens einer der einen oder der mehreren Mikro-Nano-Struktur-Einheiten (11, 22, 33, 44, 55, 66) zweidimensionale Gitter (111, 112, 113, 440, 442, 443, 444) sind, die aus Inneneinheiten unterschiedlicher Formen ausgebildet sind, und das Mikro-Nano-Struktur-Array in mindestens einer der einen oder der mehreren Mikro-Nano-Struktur-Einheiten ein zweidimensionales Gitter ist, das aus Inneneinheiten zufälliger Formen ausgebildet ist, und die Inneneinheiten zufälliger Formen zwei oder mehr Krümmungen umfassen.

2. Mikrospektrumchip nach Anspruch 1, wobei jedes des einen oder der mehreren Mikro-Nano-Struktur-Arrays ein zweidimensionales Gitter ist, das aus Inneneinheiten unterschiedlicher Formen ausgebildet ist.

3. Mikrospektrumchip nach Anspruch 1, wobei die eine oder die mehreren Mikro-Nano-Struktur-Einheiten identische Wiederholungseinheiten sind, die an entsprechenden Positionen in verschiedenen Mikro-Nano-Struktur-Einheiten angeordneten Mikro-Nano-Struktur-Arrays identisch sind, und/oder kein Mikro-Nano-Struktur-Array an einer oder mehreren entsprechenden Positionen in verschiedenen Mikro-Nano-Struktur-Einheiten vorhanden ist, und/oder jede der Mikro-Nano-Struktur-Einheiten eine Größe von 0,5 µm² bis 40000 µm² aufweist, und/oder jedes der Mikro-Nano-Struktur-Arrays eine Periode von 20 nm bis 50 pm aufweist.

4. Mikrospektrumchip nach Anspruch 1, wobei eine Anzahl von Mikro-Nano-Struktur-Arrays in jeder der Mikro-Nano-Struktur-Einheiten dynamisch einstellbar ist, und/oder die eine oder die mehreren Mikro-Nano-Struktur-Einheiten eine C4-Symmetrie aufweisen.

5. Mikrospektrumchip nach Anspruch 1, wobei jedes der Mikro-Nano-Struktur-Arrays einem oder mehreren Pixeln auf dem CIS-Wafer (2) entspricht.

6. Mikrospektrumchip nach einem der Ansprüche 1 bis 5, der ferner eine Signalverarbeitungsschaltung (3) umfasst, die über einen elektrischen Kontakt mit dem CIS-Wafer (2) verbunden ist.

7. Mikrospektrumchip nach Anspruch 1, wobei der CIS-Wafer (2) eine optische Detektionsschicht (21) und eine Metalldrahtschicht (22) umfasst, wobei die optische Detektionsschicht (21) unter der Metalldrahtschicht (22) bereitgestellt ist und die optische Modulationsschicht (1) auf der Metalldrahtschicht (22) integriert ist, oder die optische Detektionsschicht (21) über der Metalldrahtschicht (22) bereitgestellt ist und die optische Modulationsschicht (1) auf der optischen Detektionsschicht integriert ist,
wobei, wenn die optische Detektionsschicht (21) über der Metalldrahtschicht (22) bereitgestellt ist, die optische Modulationsschicht (1) durch Ätzen der optischen Detektionsschicht (21) des CIS-Wafers (2) mit einer Ätztiefe von 50 nm bis 2 µm vorbereitet wird.

8. Mikrospektrumchip nach Anspruch 1, wobei die optische Modulationsschicht (1) eine einschichtige Struktur, eine zweischichtige Struktur oder eine mehrschichtige Struktur ist und eine Dicke jeder Schicht 50 nm bis 2 µm beträgt, die optische Modulationsschicht aus einem oder mehreren der folgenden hergestellt ist: Silizium, Germanium, einem Siliziumgermanium-Material, einer Siliziumverbindung, einer Germaniumverbindung, einem Metall, oder einem Material der III-V-Gruppe, und wobei die Siliziumverbindung Siliziumnitrid, Siliziumdioxid, und/oder Siliziumkarbid umfasst, und/oder, wenn die optische Modulationsschicht eine zweischichtige Struktur oder eine mehrschichtige Struktur ist, eine oder mehrere der Schichten nicht durchdrungen sind.

9. Mikrospektrumchip nach Anspruch 1, wobei eine lichtdurchlässige Mediumschicht (4) zwischen der optischen Modulationsschicht (1) und dem CIS-Wafer (2) bereitgestellt ist, die lichtdurchlässige Mediumschicht eine Dicke von 50 nm bis 2 µm aufweist, und die lichtdurchlässige Mediumschicht (4) Siliziumdioxid umfasst, die lichtdurchlässige Mediumschicht (4) durch eine chemische Gasphasenabscheidung, ein Sputtern oder eine Rotationsbeschichtung auf dem CIS-Wafer vorbereitet wird, und anschließend die optische Modulationsschicht (1) auf der lichtdurchlässigen Mediumschicht (4) abgeschieden und geätzt wird, oder die optische Modulationsschicht (1) auf der lichtdurchlässigen Mediumschicht (4) vorbereitet wird, und anschließend die lichtdurchlässige Mediumschicht (4) und die optische Modulationsschicht (1) auf den CIS-Wafer (2) übertragen werden,
wobei der Mikrospektrumchip eine Mikrolinse und/oder ein optisches Filter umfasst, und die Mikrolinse und/oder das Lichtfilter oberhalb oder unterhalb der optischen Modulationsschicht bereitgestellt sind.

10. Verfahren zum Generieren eines Mikro-Nano-Struktur-Arrays in einem Spektrumchip nach Anspruch 1, wobei der Spektrumchip einen Bildsensor auf Waferebene (2) umfasst, und die obere Fläche eines lichtempfindlichen Bereichs des Bildsensors auf Waferebene mit einer optischen Modulationsschicht (1) bereitgestellt ist, die optische Modulationsschicht (1) ein Einheitsarray umfasst, das aus einer Mehrzahl von Mikro-Nano-Einheiten (4) ausgebildet ist, und jede der Mikro-Nano-Einheiten einem oder mehreren Pixelpunkten auf dem Bildsensor auf Waferebene entspricht, und die Mikro-Nano-Einheit mehrere Gruppen von Mikro-Nano-Struktur-Arrays umfasst, jede Gruppe der Mikro-Nano-Struktur-Arrays in einer zweidimensionalen Gitterstruktur ausgebildet ist, und die zweidimensionale Gitterstruktur in den mehreren Gruppen von Mikro-Nano-Struktur-Arrays jeder Mikro-Nano-Einheit zum Modulieren eines einfallenden Lichts und Kodieren spektraler Informationen des einfallenden Lichts an verschiedenen Pixelpunkten des Bildsensors auf Waferebene verwendet wird, um ein Bild zu erhalten, das die spektralen Informationen des einfallenden Lichts umfasst,
wobei das Verfahren zum Generieren von Mikro-Nano-Struktur-Arrays in einem Spektrumchip umfasst: Generieren der zweidimensionalen Gitterstruktur, wobei die zweidimensionale Gitterstruktur durch periodisches Anordnen zufällig geformter Strukturen ausgebildet wird, und
das Generieren der zweidimensionalen Gitterstruktur umfasst:
Schritt 101, Bestimmen einer Anordnungsperiode der zufällig geformten Strukturen in der zweidimensionalen Gitterstruktur,
Generieren jeder der zufällig geformten Strukturen in der zweidimensionalen Gitterstruktur durch die folgenden Schritte:
Schritt 102: Vermaschen eines Bereichs innerhalb der Anordnungsperiode, um eine Mehrzahl von Maschenbereichen zu erhalten,
Schritt 103: zufälliges Zuweisen von Pixelwerten zu der Mehrzahl von Maschenbereichen, um eine der zufällig geformten Struktur entsprechende Ausgangsstruktur zu erhalten, wobei Maschenbereiche, die unterschiedlichen Pixelwerten entsprechen, unterschiedliche Brechungsindizes aufweisen, und
Schritt 104: Binarisieren der Ausgangsstruktur, um eine erste binarisierte Struktur zu erhalten, wobei die erste binarisierte Struktur einer der zufällig geformten Strukturen entspricht, 0 und 1 in der ersten binarisierten Struktur jeweils Luft bzw. ein Medium repräsentieren.

11. Verfahren nach Anspruch 10, wobei die Ausgangsstruktur vor dem Binarisieren vorab gefiltert und geglättet wird,
nach dem Erhalten der ersten binarisierten Struktur ferner umfassend:
sequentielles Fuzzifizieren und Binarisieren der ersten binarisierten Struktur, um eine zweite binarisierte Struktur zu erhalten, wobei die zweite binarisierte Struktur einer zufällig geformten Struktur entspricht,
wobei das zufällige Zuweisen von Pixelwerten zu der Mehrzahl von Maschenbereichen, um die der zufällig geformten Struktur entsprechende Ausgangsstruktur zu erhalten, umfasst:
Gruppieren der Mehrzahl von Maschenbereichen, um mehrere Maschengruppen zu erhalten, wobei ein oder mehrere Maschenbereiche eine Gruppe bilden, wenn die Mehrzahl von Maschenbereichen gruppiert ist, und
zufälliges Zuweisen der Pixelwerte zu jeder Maschengruppe gemäß einer Standardnormalverteilung, um die der zufällig geformten Struktur entsprechende Ausgangsstruktur zu erhalten, wobei die Maschenbereiche in einer Gruppe denselben Pixelwert aufweisen.

12. Verfahren nach einem der Ansprüche 10 bis 11, wobei es nach dem Erhalten der ersten binarisierten Struktur oder der zweiten binarisierten Struktur ferner umfasst:
Durchführen einer Symmetrieverarbeitung an der ersten binarisierten Struktur oder der zweiten binarisierten Struktur, um eine Struktur mit Symmetrie zu erhalten, wobei die Struktur mit Symmetrie einer der zufällig geformten Strukturen entspricht,
wobei die Symmetrieverarbeitung eines oder mehrere der folgenden umfasst: Verarbeiten mit zweifacher Rotationssymmetrie, Verarbeiten mit Y-Achsen-Spiegelsymmetrie, Verarbeiten mit X-Achsen-Spiegelsymmetrie, Verarbeiten mit sowohl Y-Achsen- als auch X-Achsen-Spiegelsymmetrie, Verarbeiten mit vierfacher Rotationssymmetrie, oder Verarbeiten mit sowohl Y-Achsen als auch X-Achsen-Spiegelsymmetrie und vierfacher Rotationssymmetrie,
die Struktur mit Symmetrie eines oder mehrere der folgenden umfasst:
eine Struktur mit zweifacher Rotationssymmetrie, eine Struktur mit Y-Achsen-Spiegelsymmetrie, eine Struktur mit X-Achsen-Spiegelsymmetrie, eine Struktur mit sowohl Y-Achsen- als auch X-Achsen-Spiegelsymmetrie, eine Struktur mit vierfacher Rotationssymmetrie, oder eine Struktur mit sowohl Y-Achsen- als auch X-Achsen-Spiegelsymmetrie und vierfacher Rotationssymmetrie.

13. Verfahren nach einem der Ansprüche 10 bis 11, das nach dem Erhalten der ersten binarisierten Struktur oder der zweiten binarisierten Struktur ferner umfasst: Erweitern oder Erodieren der ersten binarisierten Struktur oder der zweiten binarisierten Struktur, um unzureichendes oder übermäßiges Ätzen in der Prozessvorbereitung zu simulieren.

14. Verfahren nach Anspruch 11, wobei der Spektrumchip ferner umfasst: eine Mikrolinse und/oder ein optisches Filter,
die Mikrolinse auf einer Seite der optischen Modulationsschicht (1) angeordnet ist, die sich fern von dem Bildsensor auf Waferebene (2) befindet, oder die Mikrolinse auf einer Seite der optischen Modulationsschicht (1) angeordnet ist, die sich nah an dem Bildsensor auf Waferebene (2) befindet, und
das Lichtfilter auf der Seite der optischen Modulationsschicht (1) angeordnet ist, die sich fern von dem Bildsensor auf Waferebene (2) befindet, oder das Lichtfilter auf der Seite der optischen Modulationsschicht (1) angeordnet ist, die sich nah an dem Bildsensor auf Waferebene (2) befindet.

## Revendications

1. Puce à spectre miniature basée sur des unités de différentes formes, comprenant un capteur d'image CMOS, une plaquette CIS (2) et une couche de modulation optique (1) ;
dans laquelle la couche de modulation optique (1) comprend une ou plusieurs unités de microstructures nanométriques (11, 22, 33, 44, 55, 66) disposées sur une surface d'une zone photosensible de la plaquette CIS (2), chaque unité de microstructures nanométriques (11, 22, 33, 44, 55, 66) comprend un ou plusieurs réseaux de microstructures nanométriques, les réseaux de microstructures nanométriques dans au moins une des unités de microstructures nanométriques (11, 22, 33, 44, 55, 66) sont des réseaux bidimensionnels (111, 112, 113, 440, 442, 443, 444) formés d'unités internes de formes différentes et le réseau de microstructures nanométriques dans au moins une d'une ou plusieurs unités de microstructures nanométriques est un réseau bidimensionnel formé d'unités internes de formes aléatoires et les unités de formes aléatoires comprennent deux courbures ou plus.

2. Puce à spectre miniature selon la revendication 1, dans laquelle chacun du ou des réseaux de micro-nanostructures est un réseau bidimensionnel formé d'unités internes de formes différentes.

3. Puce à spectre miniature selon la revendication 1, dans laquelle les unités de micro-nanostructures sont des unités répétitives identiques, les réseaux de micro-nanostructures situés à des positions correspondantes dans différentes unités de micro-nanostructures sont identiques, et/ou aucun réseau de micro-nanostructures n'existe à une ou plusieurs positions correspondantes dans différentes unités de micro-nanostructures, et/ou chacune des unités de micro-nanostructures a une taille de 0,5 µm² à 40 000 µm², et/ou chacun des réseaux de micro-nanostructures a une période de 20 nm à 50 µm.

4. Puce à spectre miniature selon la revendication 1, dans laquelle un nombre de réseaux de micro-nanostructures dans chacune des unités de micro-nanostructures est réglable dynamiquement ; et/ou, la ou les unités de structure micro-nano présentent une symétrie C4.

5. Puce à spectre miniature selon la revendication 1, dans laquelle chaque matrice de structure micro-nano correspond à un ou plusieurs pixels sur la plaquette CIS (2).

6. Puce à spectre miniature selon une quelconque des revendications 1 à 5, comprenant en outre un circuit de traitement du signal (3) connecté à la plaquette CIS (2) par contact électrique.

7. Puce à spectre miniature selon la revendication 1, dans laquelle la plaquette CIS (2) comprend une couche de détection optique (21) et une couche de fil métallique (22), dans laquelle la couche de détection optique (21) est disposée sous la couche de fil métallique (22) et la couche de modulation optique (1) est intégrée à la couche de fil métallique (22) ; ou la couche de détection optique (21) est disposée au-dessus de la couche de fil métallique (22) et la couche de modulation optique (1) est intégrée à la couche de détection optique ;
dans laquelle lorsque la couche de détection optique (21) est disposée au-dessus de la couche de fil métallique (22), la couche de modulation optique (1) est préparée par gravure de la couche de détection optique (21) de la plaquette CIS (2) avec une profondeur de gravure comprise entre 50 nm et 2 µm.

8. Puce à spectre miniature selon la revendication 1, dans laquelle la couche de modulation optique (1) est une structure monocouche, bicouche ou multicouche, et l'épaisseur de chaque couche est comprise entre 50 nm et 2 µm ; la couche de modulation optique est constituée d'un ou plusieurs des éléments suivants : silicium, germanium, matériau silicium-germanium, composé de silicium, composé de germanium, métal ou matériau du groupe III-V et dans laquelle le composé de silicium comprend du nitrure de silicium, du dioxyde de silicium et/ou du carbure de silicium et/ou lorsque la couche de modulation optique est une structure bicouche ou multicouche, une ou plusieurs couches ne sont pas traversées.

9. Puce à spectre miniature selon la revendication 1, dans laquelle une couche de milieu de transmission de lumière (4) est disposée entre la couche de modulation optique (1) et la plaquette CIS (2), la couche de milieu de transmission de lumière a une épaisseur de 50 nm à 2 µm et la couche de milieu de transmission de lumière (4) est composée de dioxyde de silicium, la couche de milieu de transmission de lumière (4) est préparée sur la plaquette CIS par dépôt chimique en phase vapeur, pulvérisation cathodique ou dépôt par centrifugation, puis la couche de modulation optique (1) est déposée et gravée sur la couche de milieu de transmission de lumière (4) ; ou la couche de modulation optique (1) est préparée sur la couche de milieu de transmission de lumière (4), puis la couche de milieu de transmission de lumière (4) et la couche de modulation optique (1) sont transférées sur la plaquette CIS (2) ;
dans laquelle la puce à spectre miniature comprend une microlentille et/ou un filtre optique et la microlentille et/ou le filtre optique sont disposés au-dessus ou en dessous de la couche de modulation optique.

10. Procédé de génération d'un réseau de micro-nanostructures dans une puce selon la revendication 1, dans lequel la puce à spectre comprend un capteur d'image (2) au niveau de la plaquette et une surface supérieure de la zone photosensible est pourvue d'une couche de modulation optique (1) ; la couche de modulation optique (1) comprend un réseau d'unités formé d'une pluralité de micro-nano-unités (4), et chacune correspond à un ou plusieurs points de pixels sur le capteur d'image au niveau de la plaquette et l'unité micro-nano comprend plusieurs groupes, chaque groupe de réseaux de micro-nanostructures est formé dans une structure de réseau bidimensionnelle et la structure de réseau bidimensionnelle dans les multiples groupes de réseaux de micro-nanostructures de chaque unité micro-nano sert à moduler une lumière incidente et à coder les informations spectrales de cette lumière incidente vers différents points de pixels du capteur d'image au niveau de la plaquette afin d'obtenir une image incluant les informations spectrales de la lumière incidente ;
dans lequel le procédé de génération de réseaux de micro-nanostructures dans une puce à spectre comprend : la génération de la structure de réseau bidimensionnelle, la structure de réseau bidimensionnelle étant formée par un agencement périodique de structures de forme aléatoire ; et
la génération de la structure de réseau bidimensionnelle comprend :
étape 101, la détermination d'une période d'agencement des structures de forme aléatoire dans la structure de réseau bidimensionnelle ;
la génération de chacune des structures de forme aléatoire dans la structure de réseau bidimensionnelle selon les étapes suivantes :
étape 102, le maillage d'une zone au cours de la période d'agencement pour obtenir une pluralité de zones de maillage ;
étape 103, attribution aléatoire de valeurs de pixels à la pluralité de zones de maillage afin d'obtenir un motif initial correspondant à la structure de forme aléatoire, dans lequel les zones de maillage correspondant à différentes valeurs de pixels ont des indices de réfraction différents ; et
étape 104 : binarisation du motif initial afin d'obtenir un premier motif binarisé, dans lequel le premier motif binarisé correspond à une des structures de forme aléatoire, 0 et 1 dans le premier motif binarisé représentent respectivement l'air et un milieu.

11. Procédé selon la revendication 10, dans lequel, avant d'être binarisé, le motif initial est filtré et lissé au préalable ;
après l'obtention du premier motif binarisé, l'opération comprend en outre :
la fuzzification et binarisation séquentielles du premier motif binarisé afin d'obtenir un deuxième motif binarisé correspondant à une structure de forme aléatoire ;
dans lequel l'attribution aléatoire de valeurs de pixels à la pluralité de zones de maillage pour obtenir le motif initial correspondant à la structure aléatoire comprend :
le regroupement de la pluralité de zones de maillage pour obtenir plusieurs groupes de maillages, dans lequel une ou plusieurs zones de maillage constituent un groupe lorsque la pluralité de zones de maillage est regroupée ; et
l'attribution aléatoire des valeurs de pixels à chaque groupe de maillages selon une distribution normale standard pour obtenir le motif initial correspondant à la structure aléatoire, dans lequel les zones de maillage d'un groupe ont la même valeur de pixel.

12. Procédé selon une quelconque des revendications 10 à 11, dans lequel, après l'obtention du premier ou du deuxième motif binarisé, l'opération comprend en outre :
la réalisation d'un traitement de symétrie sur le premier ou le deuxième motif binarisé pour obtenir un motif symétrique, dans lequel le traitement de symétrie correspond à une des structures aléatoires ;
dans lequel le traitement de symétrie comprend un ou plusieurs des éléments suivants : un traitement de symétrie à rotation double, un traitement de symétrie miroir selon l'axe Y, un traitement de symétrie miroir selon l'axe X, un traitement de symétrie miroir selon les axes Y et X, un traitement de symétrie à rotation quadruple ou un traitement de symétrie miroir selon les axes Y et X et un traitement de symétrie à rotation quadruple ;
le motif avec symétrie comprend un ou plusieurs des éléments suivants :
un motif à symétrie à rotation double, un motif à symétrie miroir selon l'axe Y, un motif à symétrie miroir selon l'axe X, un motif à symétrie miroir selon les axes Y et X, un motif à symétrie à rotation quadruple, ou un motif à symétrie miroir selon les axes Y et X et une symétrie à rotation quadruple.

13. Procédé selon une quelconque des revendications 10 à 11, après obtention du premier ou du deuxième motif binarisé, l'opération comprend en outre : la dilatation ou l'érosion du premier motif binarisé ou du deuxième motif binarisé afin de simuler une gravure insuffisante ou excessive lors de la préparation du procédé.

14. Procédé selon la revendication 11, dans lequel la puce à spectre comprend en outre : une microlentille et/ou un filtre optique ;
la microlentille est disposée sur un côté de la couche de modulation optique (1) distal par rapport au capteur d'image au niveau de la plaquette (2), ou la microlentille est disposée sur un côté de la couche de modulation optique (1) proximal par rapport au capteur d'image au niveau de la plaquette (2) ; et
le filtre de lumière est disposé sur le côté de la couche de modulation optique (1) distal par rapport au capteur d'image au niveau de la plaquette (2), ou le filtre de lumière est disposé sur le côté de la couche de modulation optique (1) proximal par rapport au capteur d'image au niveau de la plaquette (2).
